# EUROPEAN PATENT APPLICATION

(11) **EP 4 715 876 A1**
(43) Date of publication of application: **25.03.2026**
(21) Application number: 24813757.2
(22) Date of filing: 23.02.2024
(51) Int. Cl.: H01L 27/12, H01L 21/77, G02F 1/1362

(54) **ARRAY SUBSTRATE AND DISPLAY DEVICE**

(30) Priority: 30.05.2023 WO PCT/CN2023/097164
(71) Applicant: Boe Technology Group Co., Ltd., Beijing 100015 (CN); Beijing BOE Technology Development Co., Ltd., Beijing 100176 (CN)
(72) Inventor: WANG, Dongfang, Beijing 100176 (CN); SUN, Hongda, Beijing 100176 (CN); LU, Yuhang, Beijing 100176 (CN); HE, Jiayu, Beijing 100176 (CN); WANG, Haoran, Beijing 100176 (CN)
(74) Representative: Hoffmann Eitle
(86) International application number: PCT/CN2024/078447
(87) International publication number: WO 2024/244551

(57) **Abstract**

An array substrate. The array substrate comprises a base substrate, a signal line, a first insulating layer, an active layer and a first via hole, wherein the signal line is located on the base substrate; the first insulating layer is located on the side of the signal line away from the base substrate; the active layer is located on the side of the first insulating layer away from the base substrate, and comprises a first portion, a second portion, and a channel structure, which is located between the first portion and the second portion; the first via hole penetrates at least the first insulating layer, and exposes at least part of the signal line; the first portion is configured to connect to the signal line by means of the first via hole; the materials of the second portion and the first portion are the same as the material of the channel structure; and the electrical conductivity of the channel structure is different from that of the first portion, and is different from that of the second portion.

## Description

This application claims priority to International Patent Application No. PCT/CN2023/097164, filed on May 30, 2023, which is incorporated herein by reference in its entirety.

### TECHNICAL FIELD

The present disclosure relates to the field of display technologies, and in particular, to an array substrate and a display apparatus.

### BACKGROUND

Liquid crystal display panels have been widely used. Generally, the liquid crystal display panel includes: an opposite substrate and an array substrate that are disposed opposite to each other, and a liquid crystal layer between the opposite substrate and the array substrate. The array substrate may include a thin film transistor, a gate line, a signal line, and a pixel electrode, and the opposite substrate includes or the array substrate may further include a common electrode and a common electrode signal line. With the continuous development of display technology, the requirements for the liquid crystal display panel are getting higher and higher, and high pixel density is an important development direction of the crystal display panel. Improving the aperture ratio of the liquid crystal display panel is an important way to improve the pixel density of the liquid crystal display panel. How to improve the aperture ratio of the liquid crystal display panel is a technical problem that urgently needs to be solved.

### SUMMARY

In an aspect, an array substrate is provided. The array substrate includes: a base substrate, a signal line, a first insulating layer, an active layer, and a first via hole. The signal line is disposed on the base substrate. The first insulating layer is located on a side of the signal line away from the base substrate. The active layer is located on a side of the first insulating layer away from the base substrate; the active layer includes a first portion, a second portion and a channel structure located between the first portion and the second portion. The first via hole penetrates at least the first insulating layer and exposes at least part of the signal line. The first portion is configured to be connected to the signal line through the first via hole. Material of the second portion and the first portion is same as a material of the channel structure, and a conductivity of the channel structure is different from a conductivity of the first portion and a conductivity of the second portion.

In some embodiments, the array substrate further includes a connection electrode. The connection electrode is located on a side of the active layer away from the base substrate. The connection electrode is electrically connected to both the signal line and the first portion, the first portion is configured to be electrically connected to the signal line through the connection electrode.

In some embodiments, the array substrate further includes a second insulating layer. The second insulating layer is located between the active layer and the gate. The first via hole penetrates the second insulating layer and the first insulating layer, and the first via hole further exposes at least part of the first portion. At least part of the connection electrode is located in the first via hole, and an orthographic projection of the connection electrode on the base substrate partially overlaps with an orthographic projection of the first portion on the base substrate, and partially overlaps with an orthographic projection of the signal line on the base substrate.

In some embodiments, the orthographic projection of the first portion on the base substrate partially overlaps with the orthographic projection of the signal line on the base substrate.

In some embodiments, the array substrate includes a first connection region defined by the first via hole. The first connection region includes a first region, a second region, and a third region that are sequentially connected in a direction away from the channel structure. An orthogonal projection of the first region on the base substrate partially overlaps with the orthographic projection of the first portion on the base substrate, and is non-overlapping with the orthographic projection of the signal line on the base substrate. An orthogonal projection of the second region on the base substrate partially overlaps with the orthographic projection of the first portion on the base substrate, and is located within the orthographic projection of the signal line on the base substrate. An orthogonal projection of the third region on the base substrate is located outside the orthographic projection of the first portion on the base substrate, and at least partially overlaps with the orthographic projection of the signal line on the base substrate. The connection electrode covers at least part of the second region and the third region.

In some embodiments, in the first region, the array substrate comprises the first insulating layer and the first portion that are stacked; in the second region, the array substrate comprises the signal line, the first insulating layer, the first portion and the connection electrode that are stacked; and in the third region, the array substrate comprises the signal line and the connection electrode that are stacked.

In some embodiments, the connection electrode covers at least part of the first region. At the position where the first region is located, the array substrate further includes the connection electrode disposed on a side of the first portion away from the connection electrode.

In some embodiments, the connection electrode exposes at least part of the first region. The first portion includes a groove that is recessed toward the base substrate, the groove is located in the first region, and an orthographic projection of the groove on the base substrate is non-overlapping with the orthographic projection of the connection electrode on the base substrate.

In some embodiments, the signal line, the first insulating layer, the first portion, and the connection electrode form a protruding structure in the second region that protrudes toward a side away from the base substrate relative to the first region and the third region.

In some embodiments, the first portion and/or the second portion includes a zigzag structure at an edge of the second region proximate to the first region.

In some embodiments, the orthographic projection of the first portion on the base substrate is non-overlapping with the orthographic projection of the signal line on the base substrate.

In some embodiments, the orthographic projection of the first portion on the base substrate is non-overlapping with the orthographic projection of the signal line on the base substrate.

In some embodiments, the array substrate includes a first connection region defined by the first via hole, and the first connection region includes a fourth region and a fifth region that are sequentially connected in a direction away from the channel structure. An orthogonal projection of the fourth region on the base substrate at least partially overlaps with the orthographic projection of the first portion on the base substrate, and is non-overlapping with the orthographic projection of the signal line on the base substrate. An orthogonal projection of the fifth region on the base substrate at least partially overlaps with the orthographic projection of the signal line on the base substrate, and is non-overlapping with the orthographic projection of the first portion on the base substrate. The connection electrode covers at least part of the fourth region and at least part of the fifth region.

In some embodiments, in the fourth region, the array substrate comprises the first insulating layer, the first portion, and the connection electrode that are stacked; in the fifth region, the array substrate comprises the signal line and the connection electrode that are stacked.

In some embodiments, the connection electrode exposes at least part of the fourth region. The first portion includes a groove that is recessed toward the base substrate, the groove is located in the fourth region, and an orthographic projection of the groove on the base substrate is non-overlapping with the orthographic projection of the connection electrode on the base substrate.

In some embodiments, the connection electrode includes a step structure. The step structure includes a first step located in the fourth region and a second step located in the fifth region; the first step is farther away from the base substrate than the second step.

In some embodiments, the material of the first portion is different from a material of the connection electrode.

In some embodiments, the channel structure, the first portion and the second portion are of one piece structure. The material of the first portion includes M1OₐN_{b}, where M1 is a single metal or a combination of multiple metals, a > 0, and b ≥ 0, O represents oxygen element, and N represents nitrogen element. The material of the connection electrode includes a metal material.

In some embodiments, at least part of the first portion extends into the connection electrode.

In some embodiments, the array substrate further includes a second insulating layer and a gate. The second insulating layer is located between the active layer and the connection electrode. The gate is located on a side of the second insulating layer away from the base substrate. The connection electrode and the gate are located in a same layer and include a same material.

In some embodiments, the first via hole penetrates through the first insulating layer. At least part of the first portion is located in the first via hole, and the first portion is in contact with and connected to the signal line through the first via hole.

In some embodiments, the channel structure, the first portion and the second portion are of a one piece structure. The material of the first portion includes M1OaNb, wherein M1 is a single metal or a combination of multiple metals, a > 0, and b ≥ 0, O represents oxygen element, and N represents nitrogen element.

In some embodiments, the first portion, the channel structure, and the second portion are arranged substantially along a straight line.

In some embodiments, the array substrate further includes a gate line and a gate. The gate line is disposed on a side of the active layer away from the base substrate, and the gate line extends in a first direction. The gate is located in a same layer as the gate and including a same material as the gate, the gate extends in a second direction, and an end of the gate is connected to the gate line. The first portion, the channel structure, and the second portion extend substantially in the first direction. The first direction intersects the second direction. The signal line extends in the second direction.

In some embodiments, the gate line includes a first extension segment and a second extension segment; an orthographic projection of the first extension segment on the base substrate is non-overlapping with an orthographic projection of the signal line on the base substrate, and an orthographic projection of the second extension segment on the base substrate overlaps with the orthographic projection of the signal line on the base substrate. In the second direction, a dimension of the first extension segment is less than a dimension of the second extension segment.

In some embodiments, the dimension of the first extension section in the second direction is denoted as D1, and a value of D1 is in a range of 2 µm to 6 µm. The dimension of the second extension section in the second direction is denoted as D2, D2 = D1 + **H,** and a value of H is in a range of 0.2 µm to 1.5 µm.

In some embodiments, the array substrate further includes a third insulating layer, a planarization layer, a second via hole, and a pixel electrode. The third insulating layer is located on a side of the connection electrode away from the base substrate. The planarization layer is disposed on a side of the third insulating layer away from the base substrate. The second via hole penetrates at least the third insulating layer and the planarization layer, and an orthogonal projection of the second via hole on the base substrate at least partially overlaps with an orthographic projection of the second portion on the base substrate. The pixel electrode is disposed on a side of the planarization layer away from the base substrate, and the pixel electrode extends through the second via hole and is electrically connected to the second portion.

In some embodiments, the second via hole includes a first sub-hole penetrating the third insulating layer and a second sub-hole penetrating the planarization layer. An orthogonal projection of the second sub-hole on the base substrate covers an orthogonal projection of the first sub-hole on the base substrate, and a center of the orthogonal projection of the second sub-hole on the base substrate and a center of the orthogonal projection of the first sub-hole on the base substrate have a spacing therebetween.

In some embodiments, the first portion, the channel structure and the second portion are arranged substantially in the first direction. The center of the orthogonal projection of the second sub-hole on the base substrate is spaced apart from the center of the orthogonal projection of the first sub-hole on the base substrate in the first direction.

In some embodiments, the second via hole includes a first sub-hole penetrating the third insulating layer and a second sub-hole penetrating the planarization layer. A boundary of the orthogonal projection of the second sub-hole on the base substrate substantially coincides with a boundary of the orthogonal projection of the first sub-hole on the base substrate, and the center of the orthogonal projection of the second sub-hole on the base substrate substantially coincides with the center of the orthogonal projection of the first sub-hole on the base substrate.

In some embodiments, the array substrate further includes a transfer electrode located between the active layer and the third insulating layer and electrically connected to the second portion. The second via hole exposes at least part of the transfer electrode, the pixel electrode is electrically connected to the transfer electrode and is electrically connected to the second portion through the transfer electrode.

In some embodiments, the second via hole exposes at least part of the second portion, and the pixel electrode is in contact with and connected to the second portion.

In some embodiments, the array substrate further includes a supporting block located on a side of the pixel electrode away from the base substrate; an orthographic projection of the supporting block on the base substrate at least partially overlaps with an orthogonal projection of a second sub-hole on the base substrate. At least part of the second sub-hole is filled with the supporting block.

In some embodiments, the array substrate further includes a pixel electrode located in a same layer as the active layer and including a same material as the active layer; the pixel electrode and the second portion are of a one piece structure.

In some embodiments, in a section taken along a plane perpendicular to the base substrate, perpendicular to a direction in which the signal line extends in length, and intersecting the signal line and the first via hole, surfaces of the signal line except a lower surface are exposed in the first via hole; the lower surface refers to a surface of the signal line in contact with the base substrate.

In some embodiments, in the section, an upper surface of the signal line and two side surfaces each connected to both an upper surface and the lower surface of the signal line are completely covered by the first portion or the connection electrode.

In some embodiments, in the section, only an upper surface of a part of the signal line and only one of two side surfaces each connected to both an upper surface and the lower surface of the signal line are covered by the first portion or the connection electrode.

In some embodiments, in a section taken along a plane perpendicular to the base substrate, perpendicular to a direction in which the signal line extends in length, and intersecting the signal line and the first via hole, at least part of an upper surface of the signal line and at least one of two side surfaces each connected to both the upper surface and the lower surface of the signal line are not exposed in the first via hole. The lower surface refers to a surface of the signal line in contact with the base substrate.

In some embodiments, in the section, only an upper surface of a part of the signal line and at least one of the two side surfaces each connected to both the upper surface and the lower surface of the signal line are covered by the first insulating layer.

In some embodiments, in the section, only an upper surface of a part of the signal line and only one of the two side surfaces each connected to both the upper surface and the lower surface of the signal line are covered by the first portion or the connection electrode.

In some embodiments, in the section, only an upper surface of a middle portion of the signal line is covered by the first portion or the connection electrode. The two side surfaces each connected to both the upper surface and the lower surface of the signal line are covered by the first insulating layer.

In some embodiments, the signal line is configured to provide a data signal for the first portion.

In some embodiments, the active layer includes a metal oxide material with a hall mobility greater than or equal to 30 cm2/V.s.

In some embodiments, the array substrate further includes a light shielding component located on the base substrate and a gate line located on a side of the active layer away from the base substrate. The light shielding component and the signal line are located in a same layer and includes a same material. In a direction perpendicular to a direction in which the gate line extends in length, a ratio of a line width of the gate line to a line width of the light shielding component is in a range of 0.3 to 0.9.

In another aspect, a display apparatus is provided. The display apparatus includes driving circuit board and the array substrate according to any one of the above embodiments. The driving circuit board is electrically connected to the array substrate and configured to transmit a control signal to the array substrate.

### BRIEF DESCRIPTION OF THE DRAWINGS

In order to describe technical solutions in some embodiments of the present disclosure more clearly, the accompanying drawings to be used in some embodiments of the present disclosure will be introduced briefly; obviously, the accompanying drawings to be described below are merely some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a plan view of a display apparatus, in accordance with some embodiments;
FIG. 2 is a sectional view of a display apparatus, in accordance with some embodiments;
FIG. 3 is a plan view of an array substrate, in accordance with some embodiments;
FIG. 4 is a sectional view taken along the section line A-A1 in FIG. 3;
FIG. 5 is a partial enlarged view of the region S1 in FIG. 3;
FIG. 6 is another sectional view taken along the section line A-A1 in FIG. 3;
FIG. 7A is a partial enlarged view of the region S2 in FIG. 3;
FIG. 7B is another partial enlarged view of the region S2 in FIG. 3;
FIG. 7C is yet another partial enlarged view of the region S2 in FIG. 3;
FIG. 7D is yet another partial enlarged view of the region S2 in FIG. 3;
FIG. 8A is a sectional view of an array substrate, in accordance with some embodiments;
FIG. 8B is a sectional view of another array substrate, in accordance with some embodiments;
FIG. 8C is a sectional view of yet another array substrate, in accordance with some embodiments;
FIG. 8D is a sectional view of yet another array substrate, in accordance with some embodiments;
FIG. 9 is a plan view of another array substrate, in accordance with some embodiments;
FIG. 10A is a plan view of yet another array substrate, in accordance with some embodiments;
FIG. 10B is a plan view of yet another array substrate, in accordance with some embodiments;
FIG. 10C is a plan view of yet another array substrate, in accordance with some embodiments;
FIG. 10D is a plan view of yet another array substrate, in accordance with some embodiments;
FIG. 10E is a plan view of yet another array substrate, in accordance with some embodiments;
FIG. 10F is a plan view of yet another array substrate, in accordance with some embodiments;
FIG. 10G is a plan view of yet another array substrate, in accordance with some embodiments;
FIG. 11A is a sectional view taken along the section line A-A2 in FIG. 10A;
FIG. 11B is a sectional view taken along the section line A-A3 in FIG. 10D;
FIG. 11C is a sectional view taken along the section line A-A4 in FIG. 10E;
FIG. 12A is a plan view of yet another array substrate, in accordance with some embodiments;
FIG. 12B is a plan view of yet another array substrate, in accordance with some embodiments;
FIG. 12C is a plan view of yet another array substrate, in accordance with some embodiments;
FIG. 12D is a plan view of yet another array substrate, in accordance with some embodiments;
FIG. 13 is a structural diagram of a first portion and connection electrode, in accordance with some embodiments;
FIG. 14 is a diagram of a zigzag structure, in accordance with some embodiments;
FIG. 15 is a plan view of yet another array substrate, in accordance with some embodiments;
FIG. 16 is a sectional view taken along the section line A-A5 in FIG. 15;
FIG. 17 is a plan view of yet another array substrate, in accordance with some embodiments;
FIG. 18 is a sectional view taken along the section line A-A6 in FIG. 17;
FIG. 19 is a plan view of yet another array substrate, in accordance with some embodiments;
FIG. 20 is a sectional view taken along the section line A-A7 in FIG. 19;
FIG. 21A is a plan view of yet another array substrate, in accordance with some embodiments;
FIG. 21B is a plan view of yet another array substrate, in accordance with some embodiments;
FIG. 21C is a plan view of yet another array substrate, in accordance with some embodiments;
FIG. 21D is a plan view of yet another array substrate, in accordance with some embodiments;
FIG. 21E is a plan view of yet another array substrate, in accordance with some embodiments;
FIG. 22A is a plan view of yet another array substrate, in accordance with some embodiments;
FIG. 22B is a plan view of yet another array substrate, in accordance with some embodiments;
FIG. 23A is a plan view of yet another array substrate, in accordance with some embodiments;
FIG. 23B is a plan view of yet another array substrate, in accordance with some embodiments;
FIG. 24 is a sectional view taken along the section line C-C in FIG. 23A or FIG. 23B;
FIG. 25 is a plan view of yet another array substrate, in accordance with some embodiments;
FIG. 26 is a sectional view taken along the section line D-D in FIG. 25;
FIG. 27 is a plan view of yet another array substrate, in accordance with some embodiments;
FIG. 28 is a sectional view taken along the section line E-E in FIG. 27;
FIG. 29A is a sectional view of yet another array substrate, in accordance with some embodiments;
FIG. 29B is a sectional view of yet another array substrate, in accordance with some embodiments;
FIG. 29C is a sectional view of yet another array substrate, in accordance with some embodiments;
FIG. 29D is a sectional view of yet another array substrate, in accordance with some embodiments;
FIGS. 30A to 30C are diagrams showing manufacturing steps of an array substrate, in accordance with some embodiments;
FIGS. 31A to 31C are diagrams showing manufacturing steps of another array substrate, in accordance with some embodiments;
FIGS. 32Ato 32B are diagrams showing manufacturing steps of yet another array substrate, in accordance with some embodiments;
FIGS. 33Ato 33C are diagrams showing manufacturing steps of yet another array substrate, in accordance with some embodiments;
FIGS. 34Ato 34C are diagrams showing manufacturing steps of yet another array substrate, in accordance with some embodiments;
FIGS. 35Ato 35B are diagrams showing manufacturing steps of yet another array substrate, in accordance with some embodiments;
FIGS. 36Ato 36C are diagrams showing manufacturing steps of yet another array substrate, in accordance with some embodiments; and
FIGS. 37Ato 37C are diagrams showing manufacturing steps of yet another array substrate, in accordance with some embodiments.

### DETAILED DESCRIPTION

The technical solutions in some embodiments of the present disclosure will be described clearly and completely with reference to the accompanying drawings; obviously, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

In the present disclosure, terms such as "lower", "below", "above", "upper", and the like are used to explain the relational association of components shown in the drawings. The terms may be relative concepts and described based on the directions shown in the drawings, or based on the order in which the process steps are formed, but are not limited thereto.

It will be understood that, in a case where a layer or element is referred to as being on another layer or substrate, the layer or element may be directly on the another layer or substrate, or there may be intermediate layer(s) between the layer or element and the another layer or substrate.

The term "opposed to" means that a first element may be directly or indirectly opposed to a second element. In the case where a third element is interposed between the first element and the second element, the first element and the second element may be understood as being indirectly opposite to each other although still opposite to each other.

The terms "first" and "second" are used for descriptive purposes only, and are not to be construed as indicating or implying a relative importance or implicitly indicating the number of indicated technical features. Thus, a feature defined with "first" or "second" may explicitly or implicitly include one or more of the features. In the description of the embodiments of the present disclosure, the term "a plurality of" or "the plurality of" means two or more unless otherwise specified.

In the description of some embodiments, the expressions "coupled", "connected", and derivatives thereof may be used. The term "connected" should be understood in a broad sense. For example, the term "connected" may represent a fixed connection, a detachable connection, or a one-piece connection, or may represent a direct connection, or may represent an indirect connection through an intermediate medium. The term "coupled" indicates that two or more components are in direct physical or electrical contact with each other. The terms "coupled" or "communicatively coupled" may also mean that two or more components are not in direct contact with each other, but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

The use of "applicable to" or "configured to" herein indicates an open and inclusive expression, which does not exclude devices that are applicable to or configured to perform additional tasks or steps.

In addition, the use of the phrase "based on" is meant to be open and inclusive, since a process, step, calculation or other action that is "based on" one or more of the stated conditions or values may, in practice, be based on additional conditions or values other than those stated.

The term such as "about", "substantially", or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular", or "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; the term "equal" includes absolute equality and approximate equality, and an acceptable range of deviation of the approximate equality may be that, for example, a difference between the two that are equal is less than or equal to 5% of either of the two.

It should be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views that are schematic illustrations of idealized embodiments. In the accompanying drawings, thicknesses of layers and sizes of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in a device, and are not intended to limit the scope of the exemplary embodiments.

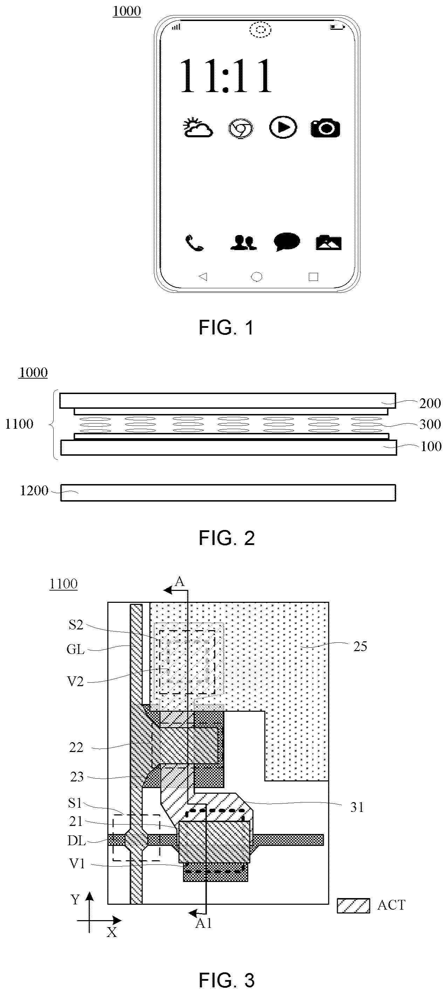

Referring to FIG. 1, some embodiments of the present disclosure provide a display apparatus, and the display apparatus 1000 is a product that have a function of displaying images. For example, the display apparatus 1000 may be any apparatus that displays images whether in motion (e.g., videos) or stationary (e.g., static images), and whether literal or graphical.

For example, the display apparatus 1000 may be a television, a laptop computer, a tablet computer, a personal digital assistant (PDA), a mobile phone (cell phone), a watch, a clock, a calculator, a GPS receiver/navigator, a camera, a display of a camera view (e.g., a display of a rearview camera in a vehicle), a wearable device, an augmented reality (AR) device, a virtual reality (VR) device, a mixed reality (MR) device, a vehicle-mounted display, a flight display, or any other product or component with a display function.

From the perspective of the light emission type of the display apparatus 1000, the display apparatus 1000 may be a liquid crystal display apparatus (LCD), or an organic light-emitting diode (OLED) display apparatus, a quantum dot light-emitting diode (QLED) display apparatus, or a mini/micro light-emitting diode (MLED) display apparatus. From the perspective of the form of the display apparatus 1000, the display apparatus 1000 may be flat display apparatus, a curved display apparatus, or a foldable display apparatus. From the perspective of the shape of the display apparatus 1000, the display apparatus 1000 may be in a shape of a rectangle or circle. Some embodiments of the present disclosure are schematically described below by taking an example in which the display apparatus is in a shape of a rectangle and is a flat liquid crystal display apparatus, but the implementations of the present disclosure are not limited to this, and any other display apparatus may also be considered as long as the same technical concept is applied.

In some embodiments, the display apparatus 1000 includes a display panel 1100, and a driving circuit board. The driving circuit board includes, for example, driving circuits such as a timing controller (TCON), a power management chip DC/DC, and an adjustable resistance voltage division circuit (for generating Vcom). The driving circuit board may also include other circuit structures, which will not be listed here one by one. The driving circuit board is electrically connected to the display panel 1100, and used for providing control signals for the display panel 1100, so as to drive the display panel 1100 to realize image display. In addition, the display apparatus 1000 may further include a touch structure, an under-screen camera, an under-screen fingerprint recognition sensor and the like, so that the display apparatus 1000 is able to implement various functions such as touch, taking pictures, video recording, fingerprint recognition, or face recognition, which is not limited here.

In a case where the display apparatus 1000 is a liquid crystal display apparatus, referring to FIG. 2, the display apparatus 1000 further includes a backlight source 1200 disposed on a backlight side of the display panel 1100. For example, the backlight source 1200 may be a direct-type backlight source or an edge-type backlight source. The backlight source 1200 is used to provide backlight for the display panel 1100, and the display panel is able to adjust the amount of light passing through the display panel 1100, thereby displaying different grayscales.

With continued reference to FIG. 2, in a case where the display panel 1100 is a liquid crystal display panel, the display panel 1100 may include: an array substrate 100 and an opposite substrate 200 (also referred to as a color filter substrate or an encapsulate substrate) that are oppositely arranged, and a liquid crystal layer 300 arranged between the array substrate 100 and the opposite substrate 200. The opposite substrate 200 may filter the light entering the opposite substrate 200 so that each subpixel emits light of one color (such as red, green and blue), and different sub-pixels may emit light of the same or different colors, thereby enabling the display panel 1100 to achieve color display. Of course, the display panel 1100 may also include other structures as long as the same technical concept is adopted. For example, the display panel 1100 further includes: a first polarizer (not shown in the figure) disposed on a side of the array substrate 100 proximate to the liquid crystal layer 300 and a second polarizer (not shown in the figure) disposed on a side of the opposite substrate 102 proximate to the liquid crystal layer 300.

The array substrate 100 may include a display area and a peripheral area arranged around the display area. The display area may include a plurality of pixel circuits, pixel electrodes and a common electrode, and the peripheral area may include, for example, a gate driver on array (GOA).

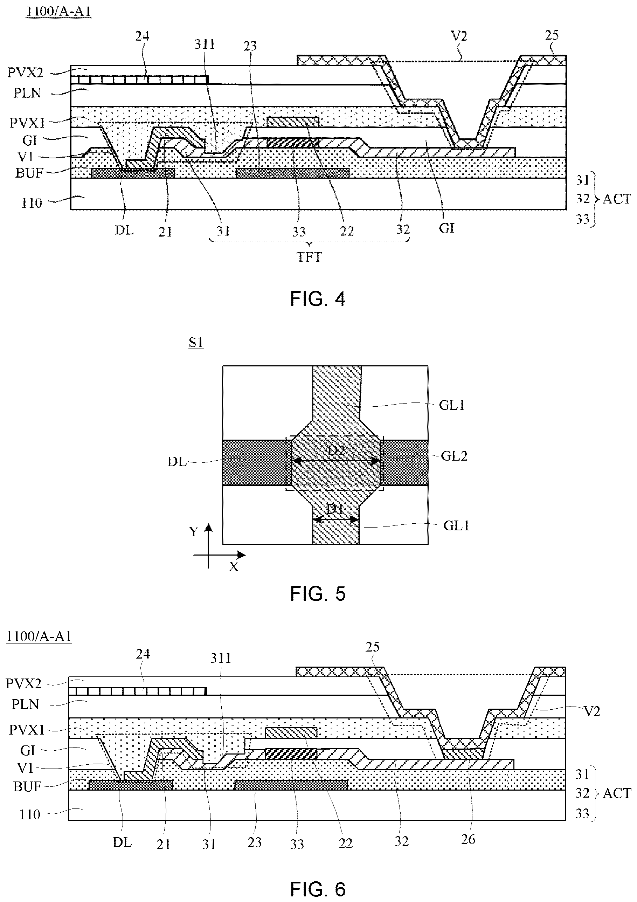

FIG. 3 is a planar partial enlarged view of the array substrate in a display area AA; FIG. 4 is a sectional view of the array substrate in a display area AA. In some embodiments, referring to FIGS. 3 and 4, the array substrate 100 includes a base substrate 110, a signal line DL, a first insulating layer BUF, an active layer ACT, and a first via hole V1.

For example, the base substrate 110 may be a transparent substrate, such as a glass substrate. In this way, the light emitted by the backlight source can pass through the base substrate 110, which is beneficial to improving the light transmittance of the array substrate 100. The signal line DL is disposed on the base substrate 110, and the signal line DL may be a data signal line configured to transmit a data signal. Of course, in some other embodiments, the signal line may also be used to transmit other signals as long as the same technical concept is adopted.

The first insulating layer BUF is disposed on a side of the signal line DL away from the base substrate 110. The first insulating layer BUF may include an insulating material, and the first insulating layer BUF may be used to cover at least part of the signal line DL to prevent the signal line DL from being short-circuited with a conductive structure (e.g., a gate line GL) disposed on an upper side of the signal line DL.

The active layer ACT is located on a side of the first insulating layer BUF away from the base substrate 110. For example, the active layer ACT includes a plurality of active layer patterns, and an active layer pattern is configured to form a thin film transistor (TFT). In other words, a thin film transistor may include an active layer pattern. A thin film transistor and an active layer pattern are exemplarily shown in FIGS. 3 and 4.

The active layer ACT includes a first portion 31, a second portion 32, and a channel structure 33 located between the first portion 31 and the second portion 32. The channel structure 33 is configured to form a channel structure of a TFT, one of the first portion 31 and the second portion 32 is configured to form a source (or a source connection region) of the TFT, and the other is configured to form a drain (or a drain connection region) of the TFT.

The first via hole V1 penetrates at least the first insulating layer BUF and exposes at least part of the signal line DL, which facilitates the connection between the first portion 31 and the signal line DL. The first portion 31 is configured to be connected to the signal line DL through the first via hole V1, so that the signal line DL transmits a signal to the first portion 31.

In the related art, the signal line is generally arranged on a side of the active layer away from the base substrate, that is, the signal line is generally arranged on the upper side of the active layer. In this way, the spacing between the signal line and other electrodes or electrode lines, such as a common electrode (arranged on the side of the active layer away from the base substrate), is small, resulting in a large parasitic capacitance formed between the signal line and the common electrode. Furthermore, the parasitic capacitance has become an important factor restricting the array substrate from improving pixel density and refresh rate, and moreover, the parasitic capacitance will also increase the power consumption of the array substrate.

In the array substrate 100 provided by the embodiments of the present disclosure, as shown in FIGS. 3 and 4, the signal line DL is arranged on the side of the active layer ACT proximate to the base substrate 110, which is beneficial to increase the spacing between the signal line DL and the common electrode, thereby reducing the parasitic capacitance between the signal line DL and the common electrode. As a result, it is beneficial to improve the pixel density and refresh rate of the array substrate 100, and is beneficial to reduce the power consumption of the signal line DL, thereby reducing the overall power consumption of the array substrate 100.

In some embodiments, a material of the signal line DL may include a conductive material, and the conductive material may include a metal material, such as one or more of titanium, aluminum, copper, molybdenum, niobium, nickel and alloy thereof. Alternatively, the signal line DL may be of a metal stacked structure. For example, the signal line DL may include one of a titanium-aluminum-titanium (Ti/Al/Ti) stacked structure, a molybdenum-aluminum (Mo/Al) stacked structure, a molybdenum-aluminum-molybdenum (Mo/Al/Mo) stacked structure, a molybdenum niobium-titanium (MoNb/Ti) stacked structure, a molybdenum niobium-titanium-copper (MoNb/Ti/Cu) stacked structure, a molybdenum niobium-copper-molybdenum titanium nickel (MoNb/Cu/MTD) stacked structure, a molybdenum-neodymium-copper stacked structure, a MoNb-copper-MoNb stacked structure, and an AlNb-molybdenum-AlNd stacked structure. Of course, the embodiments of the present disclosure are not limited to the above, and the signal line DL may also be made of any other suitable metal or metal stacked structure. In addition, a thickness of the signal line DL may be in a range of 1000 angstroms to 10000 angstroms (1 angstrom = 10⁻¹⁰ m). For example, the thickness of the signal line DL may be 1000 angstroms, 2000 angstroms, 5500 angstroms or 10000 angstroms, which will not be listed one by one in the embodiments of the present disclosure.

For example, the material of the first insulating layer BUF may include silicon oxide (SiOx, x>0). In some embodiments, the value of x may be 1 or 2. The material of the first insulating layer BUF may also include silicon nitride (SiNy, y>0). In some embodiments, the value of y may be in a range of 1 to 2, such as SiN and SiN_{1.33}. The first insulating layer BUF may be of a single layer or a stacked layer structure. In addition, the first insulating layer BUF is of a stacked layer structure including a silicon oxide compound and a silicon nitride compound. In addition, the thickness of the first insulating layer BUF may be in a range of 100 nm to 700 nm. For example, the thickness of the first insulating layer BUF may be 100 nm, 300 nm, 550 nm or 700 nm, which will not be listed one by one in the embodiments of the present disclosure.

In some embodiments, the active layer ACT includes a metal oxide material with hall mobility in a range of 10 to 30 cm²/V.s. In some embodiments, the active layer ACT includes a metal oxide material with hall mobility greater than or equal to 30 cm²/V.s.

For example, the channel structure 33 may be manufactured by using various suitable semiconductor materials and various suitable manufacturing methods, or in other words, the material of the channel structure 33 may include at least one of various suitable semiconductor materials. In some embodiments, the semiconductor material includes M1OaNb, where M1 is a single metal or a combination of multiple metals, a > 0, and b ≥ 0, O represents oxygen element, and N represents nitrogen element; that is, the semiconductor material is a metal oxide material or a metal oxynitride material. Suitable metal oxide materials include, but are not limited to, one or more materials of indium gallium zinc oxide (IGZO), indium gallium tin oxide (IGTO), indium tin zinc oxide (ITZO), indium gallium oxide (IGO), indium gallium zinc tin oxide (IGZTO), indium zinc oxide (IZO), zinc tin oxide (ZTO), indium-free metal oxide (In-free OS), rare-earth-doped oxide (Ln-OS), zinc oxide (ZnO), gallium oxide (GaO), indium oxide (InO), hafnium indium ZnO (HfInZnO, HIZO), ZnO:fluorine (F), indium oxide (In2O3):stannum (Sn), In2O3:Mo, cadmium tin oxide (Cd2SnO4), ZnO:Al, titanium dioxide (TiO₂):Nb and Cd-Sn-O. The material of the channel structure 33 may be in a form of amorphous, partially crystalline, single crystal or polycrystalline, or may be of a single layer or multi-layer structure.

Suitable metal oxynitride materials include, but are not limited to, zinc oxynitride, indium oxynitride, gallium oxynitride, tin oxynitride, cadmium oxynitride, aluminum oxynitride, germanium oxynitride, titanium oxynitride, silicon oxynitride, or combinations thereof. In an example, the material of the channel structure 33 includes indium gallium zinc oxide (IGZO).

In some embodiments, the second portion 32, the first portion 31, and the channel structure 33 may be of a one piece structure. In this case, the materials of the second portion 32 and the first portion 31 are both the same as the material of the channel structure 33; that is, the first portion 31, the second portion 32, and the channel structure 33 are located in a same layer and include a same material. Based on this, the conductive material used for forming the first portion 31 and the second portion 32 also includes M1OaNb, where M1 is a single metal or a combination of multiple metals, a > 0, and b ≥ 0, O represents oxygen element, and N represents nitrogen element. That is, the materials of the second portion 32 and the first portion 31 may be metal oxide materials or metal oxynitride materials. Suitable metal oxide materials include, but are not limited to, one or more materials of indium gallium zinc oxide (IGZO), indium gallium tin oxide (IGTO), indium tin zinc oxide (ITZO), indium gallium oxide (IGO), indium gallium zinc tin oxide (IGZTO), indium zinc oxide (IZO), zinc tin oxide (ZTO), indium-free metal oxide (In-free OS), rare-earth-doped oxide (Ln-OS), zinc oxide (ZnO), gallium oxide (GaO), indium oxide (InO), hafnium indium ZnO (HfInZnO, HIZO), ZnO:fluorine (F), indium oxide (In2O3):stannum (Sn), In2O3:Mo, cadmium tin oxide (Cd2SnO4), ZnO:Al, titanium dioxide (TiO2):Nb and Cd-Sn-O. The material of the channel structure 33 may be in a form of amorphous, partially crystalline, single crystal or polycrystalline, or may be of a single layer or multi-layer structure.

Suitable metal oxynitride materials include, but are not limited to, zinc oxynitride, indium oxynitride, gallium oxynitride, tin oxynitride, cadmium oxynitride, aluminum oxynitride, germanium oxynitride, titanium oxynitride, silicon oxynitride, or combinations thereof. The material of the first portion 31 or the second portion 32 is the same as that of the channel structure 33. In an example, the material of the first portion 31 and the second portion 32 includes indium gallium zinc oxide (IGZO).

In a case where the first portion 31, the second portion 32 and the channel structure 33 are of a one piece structure, and the materials of the channel structure 33, the first portion 31 and the second portion 32 all include M1OaNb, the difference between the first portion 31 and second portion 32 and the channel structure 33 is that the first portion 31 and the second portion 32 undergo a process that makes them more conductive. The conductivity of the channel structure 33 is different from the conductivity of the first portion 31 and different from the conductivity of the second portion 32.

For example, the channel structure 33 may include a semiconductor material, and the second portion 32 and the first portion 31 may include a doped semiconductor material. In this way, the second portion 32 and the first portion 31 may form a conductor, and the channel structure 33 may form a semiconductor.

In an example, in the case where the materials of the channel structure 33, the first portion 31, and the second portion 32 all include M1OaNb, a lightly doping process (e.g., a lightly doping ion implantation process) is performed on the M1OaNb in the first portion 31 and the second portion 32. In another example, in the case where the materials of the channel structure 33, the first portion 31, and the second portion 32 include M1OaNb, an annealing process is performed on the M1OaNb in the first portion 31 and the second portion 32. In another example, in the case where the material of the channel structure 33, the first portion 31, or the second portion 32 includes M1OaNb, an oxide replenishment process is performed on the M1OaNb in the first portion 31 or the second portion 32. For example, a doping concentration in a range of about 1×10¹⁵ atoms/cm³ to about 1×10²⁰ atoms/cm³ may be used; for example, a light doping process may be performed using a doping concentration in a range of about 1×10¹⁵ atoms/cm³ to about 1×10¹⁶ atoms/cm³, a range of about 1×10¹⁶ atoms/cm³ to about 1×10¹⁷ atoms/cm³, a range of about 1×10¹⁷ atoms/cm³ to about 1×10¹⁸ atoms/cm³, a range of about 1×10¹⁸ atoms/cm³ to about 1×10²⁰ atoms/cm³, or a range of about 1×10¹⁹ atoms/cm³ to about 1×10²⁰ atoms/cm³. For example, a lightly doping process is performed using an N-type dopant to enhance conductivity. The N-type dopant may include, for example, an element of Group VA in the periodic table, including but not limited to nitrogen (N), phosphorus (P), arsenic (As), antimony (Sb), and bismuth (Bi). Alternatively, the light doping process may be performed using a protective gas element, such as argon (Ar), helium (He), or oxygen (O).

As used herein, the term "same layer" represents the relationship between layers that are simultaneously formed in a same step. In an example, in a case where the first portion 31, the second portion 32, and the channel structure 33 are formed as one or more steps of a same patterning process performed on the materials deposited in a same deposition process, the first portion 31, the second portion 32, and the channel structure 33 are located in the same layer. The term "same layer" does not always mean that the thickness of the layer or the height of the layer in the sectional view is the same.

In some other embodiments, the first portion 31 and the second portion 32 are made of different metal materials from that of the channel structure 33. For example, the first portion 31 or the second portion 32 may be manufactured by using various appropriate conductive materials and various appropriate manufacturing methods. Suitable conductive materials may include metals, alloys, metal oxides, and any combination thereof. For example, suitable conductive materials include, but are not limited to, molybdenum, aluminum, titanium, gold, copper, hafnium, tantalum, alloy (e.g., aluminum neodymium (AINd), or molybdenum niobium (MoNb)), or a stacked material, such as a molybdenum-neodymium-copper stacked structure, a molybdenum-nickel-titanium (MTD) stacked structure, a molybdenum-nickel-titanium-copper stacked structure, a molybdenum-nickel-titanium-copper-molybdenum-nickel-titanium stacked structure, a molybdenum-neodymium-copper stacked structure, a molybdenum-aluminum-aluminum stacked structure, a molybdenum-aluminum-molybdenum stacked structure, a MoNb-copper-MoNb stacked structure, or an AINb-molybdenum-AINd stacked structure. In this case, the first portion 31, the second portion 32 and the channel structure 33 may be formed separately by using different steps.

In some embodiments, referring to FIG. 4, the array substrate 100 further includes a light shielding component 23 located on the base substrate 110. Optionally, the light shielding component 23 and the signal line SL are located in the same layer. For example, the light shielding component 23 and the signal line SL are formed by the same patterning process using the same mask plate and/or the same material. The light shielding component 23 is configured to prevent light from being directed to the channel structure 33. For example, an orthographic projection of the light shielding component 23 on the base substrate 110 overlaps at least partially (e.g., at least 50%, at least 60%, at least 70%, at least 80%, at least 90%, at least 95%, at least 98%, at least 99% or 100%) with an orthographic projection of the channel structure 33 on the base substrate 110.

In an example, as shown in FIG. 3, the orthographic projection of the light shading component 23 on the base substrate 110 completely covers the orthographic projection of the channel structure 33 on the base substrate 110, and at least part of the boundary of the orthographic projection of the light shading component 23 on the base substrate 110 is non-overlapping with the boundary of the orthographic projection of the channel structure 33 on the base substrate 110. That is, an area of the light shading component 23 is greater than an area of the channel structure 33, so that the light shading component 23 can block as much light as possible from being directed to the channel structure 33.

Referring to FIG. 4, the array substrate 100 further includes a second insulating layer GI. The second insulating layer GI is located on a side of the active layer ACT away from the first insulating layer BUF. For example, the second insulating layer GI is located on a side of the first portion 31, the channel structure 33, and the second portion 32 away from the first insulating layer BUF.

A material of the second insulating layer GI may include an insulating material, and the insulating material may be, for example, silicon oxide, and the second insulating layer GI is not limited thereto, and any other suitable material may be used. The second insulating layer GI may be of a single-layer structure or a multi-layer structure. A thickness of the second insulating layer 132 is in a range of 600 angstroms to 2000 angstroms. For example, the thickness of the second insulating layer GI may be 600 angstroms, 1000 angstroms, 1500 angstroms or 2000 angstroms, etc., which will not be listed one by one in the embodiments of the present disclosure.

In some embodiments, referring to FIGS. 3 and 4, the array substrate 100 further includes: a gate 22 and a gate line GL, and the gate 22 and the gate line GL are both located on a side of the second insulating layer GI away from the channel structure 33.

The material of the gate 22 may include a metal material. For example, the gate 22 may be of a metal stacked structure. The metal stacked structure may refer to the metal stack structure of the signal line DL mentioned above, which will not be repeated here. The material of the gate 22 may be the same as the material of the signal line DL, or the material of the gate 22 may be different from the material of the signal line DL. In addition, a thickness of the gate 22 may be in range of 200 nm to 1200 nm. For example, the thickness of the gate 22 may be 200 nm, 500 nm, 950 nm or 1200 nm, etc., which will not be listed one by one in the embodiments of the present disclosure.

The size of the gate 22 may limit the area of the channel structure 33. For example, the orthographic projection of the channel structure 33 on the base substrate 110 is located within an orthographic projection of the gate 22 on the base substrate 110. In other words, a portion of the active layer ACT where the orthographic projection on the base substrate 110 coincides with the orthographic projection of the gate 22 on the base substrate 110 is the channel structure 33, a portion of the active layer ACT located on a side of the channel structure 33 proximate to the first via hole V1 is the first portion 31, and a portion of the active layer ACT located on a side of the channel structure 33 away from the first via hole V1 is the second portion 32.

The gate 22, the first portion 31, the second portion 32 and the channel structure 33 together form a thin film transistor. One of the first portion 31 and the second portion 32 forms a source of the thin film transistor (for example, the first portion 31 forms the source), and the other forms a drain of the thin film transistor (for example, the second portion 32 forms the drain), the channel structure 33 forms a channel of the thin film transistor, and the gate 22 forms a gate of the thin film transistor. The thin film transistor is turned on or off under the control of the gate 22. In other words, the channel structure 33 electrically connects the first portion 31 to the second portion 32 under the control of the gate 22 (the thin film transistor is turned on), or the channel structure 33 electrically insulates the first portion 31 from the second portion 32 under the control of the gate 22 (the thin film transistor is turned off).

The gate line GL is a gate line configured to provide a gate driving signal for the thin film transistor. In some embodiments, the gate line GL is connected to the gate electrode 22. For example, the gate line GL and the gate 22 are located in the same layer and include the same material, and the gate line GL and the gate electrode 22 are of a one piece structure. The gate 22 may be regarded as a branch structure extending outward (perpendicular to an extension direction X of the gate line GL) of the gate line GL.

In the embodiments of the present disclosure, the length direction (extension direction) of the gate line GL is taken as a first direction Y, and the length direction (extension direction) of the signal line DL is taken as a second direction X. The first direction Y and the second direction X intersect; for example, the first direction Y and the second direction X are perpendicular to each other.

In some embodiments, in the extension direction (the second direction X) of the signal line DL in length, a ratio of a line width of the gate line GL to a line width of the light shielding component 23 is in a range of 0.3 to 0.9, inclusive. For example, the ratio of the line width of the gate line GL to the line width of the light shielding component 23 is in a range of 0.3 to 0.4, 0.4 to 0.5, 0.5 to 0.6, 0.6 to 0.7, 0.7 to 0.8 or 0.8 to 0.9, inclusive. The inventors of the present disclosure have found through such a layout that, it is possible to ensure light shielding, maintain the aperture ratio of the array substrate, so as to avoid a short circuit between the gate line GL and the light shielding component 23.

In some embodiments, the first portion 31, the channel structure 33, and the second portion 32 are arranged substantially along a straight line. That is, the first portion 31, the channel structure 33, and the second portion 32 extend substantially along a straight line. Thus, it is beneficial to reducing the width of the thin film transistor, which reduces the area of the black matrix of the opposing substrate, and facilitate the improvement of the aperture ratio of the array substrate, thereby improving the pixel density of the array substrate.

It will be noted that the opposite substrate may include a black matrix, and an orthographic projection of the black matrix on the array substrate covers at least the thin film transistor. The black matrix may reduce the ambient light directed to the thin film transistor, thereby reducing the reflection of the ambient light by the thin film transistor and improving the display quality of the display panel.

In some embodiments, referring to FIG. 3, the first portion 31, the channel structure 33, and the second portion 32 extend substantially in the first direction Y, that is, the arrangement direction of the first portion 31, the channel structure 33, and the second portion 32 is substantially parallel to the extension direction of the gate line GL, and the first portion 31, the channel structure 33, and the second portion 32 are arranged close to the gate line GL. Thus, it is possible to reduce the space occupied by the thin film transistor and the gate line GL in the second direction X greatly, and reduce the area of the black matrix of the opposite substrate greatly, which is beneficial to improving the aperture ratio of the array substrate, thereby improving the pixel density of the array substrate.

Referring to FIGS. 3 and 5, the orthographic projection of the gate line GL on the base substrate 110 partially overlaps with the orthographic projection of the signal line DL on the base substrate 110. The gate line GL includes a first extension segment GL1 and a second extension segment GL2. An orthographic projection of the first extension segment GL1 on the base substrate 110 is non-overlapping with the orthographic projection of the signal line DL on the base substrate 110, and an orthographic projection of the second extension segment GL2 on the base substrate 110 overlaps with the orthographic projection of the signal line DL on the base substrate 110. In this way, there is a height difference between the planes where the first extension segment GL1 and the second extension segment GL2 are located. In other words, the first extension segment GL1 and the second extension segment GL2 have an undulating morphology relative to the base substrate at the connection position therebetween. In the second direction X, a dimension D1 of the first extension segment GL1 is less than a dimension D2 of the second extension segment. In this way, it is possible to reduce the risk of a sudden change in resistance or connection failure (e.g., breakage) at the connection position between the first extension segment GL1 and the second extension segment GL2, thereby improving the reliability of the gate line GL.

For example, as shown in FIG. 5, the dimension of the first extension segment GL1 in the second direction X is denoted as D1, and a value of D1 is in a range of 2 µm to 6 µm. The dimension of the second extension segment GL2 in the second direction X is denoted as D2, D2 = D1 + H, and a value of H is in a range of 0.2 µm to 1.5 µm. That is, the line width of the first extension segment GL1 is in a range of 2 µm to 6 µm, and the line width of the second extension segment GL2 is in a range of 0.2 µm to 1.5 µm greater than the line width of the first extension segment GL1. For example, as the line width of the first extension segment GL1 increases, the risk of the gate line GL breaking or a sudden change in resistance at the junction of the first extension segment GL1 and the second extension segment GL2 decreases. Based on this, the value of H may decrease as the line width of the first extension segment GL1 increases.

For example, the line width of the first extension segment GL1 may be in a range of 2 µm to 2.5 µm, 2.5 µm to 3 µm, 3 µm to 4 µm, or 4 µm to 6 µm. For example, in order to improve the pixel density and aperture ratio of the array substrate, the line width of the first extension segment GL1 may be in a range of 2 µm to 2.5 µm. For example, the value of H is 0.2 µm, 0.5 µm, 1 µm or 1.5µm.

In some embodiments, the array substrate may further include a gate driving circuit and at least one second gate line driving the gate driving circuit that are located in the peripheral area. The gate driving circuit may include a plurality of thin film transistors. The second gate line is used to control the plurality of thin film transistors of the gate driving circuit. Since the wiring space in the peripheral area is larger, the line width of the second gate line may be set greater than the line width of the gate line, that is, the line width of the second gate line in the peripheral area is greater than the line width of the gate line in the display area AA.

In some embodiments, the line width of the second gate line is uniform in a length direction of the second gate line. In other words, the second gate line is not widened in area region where the second gate line overlaps with the underlying signal line (the signal line located on the side of the second gate line proximate to the base substrate). Alternatively, in some embodiments, in the length direction of the second gate line, at least a portion of the second gate line has a line width wider than other portions. For example, the line width of the portion overlapping with the underlying signal line (the signal line located on the side of the second gate line proximate to the base substrate) of the second gate line is wider than that of other portions of the second gate line. Alternatively, no wiring is arranged on a side of the second gate line proximate to the base substrate in the peripheral area.

In some embodiments, referring to FIGS. 3 and 4, the array substrate 100 further includes a third insulating layer PVX1, a planarization layer PLN, a common electrode 24, a fourth insulating layer PVX2, a pixel electrode 25, and a second via hole V2. The third insulating layer PVX1 is disposed on a side of the gate 22 away from the base substrate 110. The planarization layer PLN is disposed on a side of the third insulating layer PVX1 away from the base substrate 110. The common electrode 24 is located on a side of the planarization layer PLN away from the base substrate 110. The fourth insulating layer PVX2 is located on a side of the common electrode 24 away from the base substrate 110. The pixel electrode 25 is located on a side of the fourth insulating layer PVX2 away from the base substrate 110.

In some other embodiments, the array substrate may include no planarization layer PLN, and the common electrode is directly disposed on the third insulating layer. Alternatively, in some other embodiments, the pixel electrode 25 may be located in the same layer as the active layer ACT and include the same material (not shown in the figure); in this case, the pixel electrode 25 and the second portion 32 are of a one piece structure, which is beneficial to reduce the number of film layers of the array substrate, so as to reduce the thickness of the array substrate, and reduce the manufacturing cost of the array substrate. Of course, the film layer structure and film layer sequence of the array substrate in the embodiments of the present disclosure are not limited thereto, and other suitable film layers or structures may be considered to be included, or at least one film layer or structure may be considered to reduce, as long as the same technical concept is adopted. The following embodiments of the present disclosure will be described by taking an example in which the array substrate 100 includes a film layer structure as shown in FIG. 4.

In some embodiments, in the case where the array substrate 100 is a liquid crystal display array substrate. The pixel electrode 25 is a respective pixel electrode in each of a plurality of sub-pixels in the liquid crystal display array substrate. The common electrode 24 is a common electrode in the liquid crystal display array substrate. In an example, the common electrode 24 is an electrode extending over the plurality of sub-pixels in a liquid crystal display array substrate.

In some embodiments, in the case where the array substrate is a light-emitting diode display array substrate. The pixel electrode 25 is a respective anode of each light-emitting diode in the light-emitting diode display array substrate. The common electrode 24 is a cathode in the light-emitting diode display array substrate. In an example, the common electrode is a cathode extending over the plurality of sub-pixels in the light-emitting diode display array substrate. In another example, the common electrode layer is located on a side of the light-emitting layer and the pixel electrode PE away from the base substrate 110.

The second via hole V2 penetrates at least the third insulating layer PVX1 and the planarization layer PLN. For example, as shown in FIG. 4, the second via hole V2 further penetrates the fourth insulating layer PVX2 and the third insulating layer GI. An orthogonal projection of the second via hole K1 on the base substrate 110 at least partially overlaps with an orthographic projection of the second portion 32 on the base substrate 110, which facilitate the connection between the pixel electrode 25 and the second portion 32. The pixel electrode 25 extends into the second via hole V2 and is electrically connected to the second portion 32.

In some embodiments, as shown in FIG. 4, the second via hole V2 further penetrates the second insulating layer GI and the fourth insulating layer PVX2, and the second via hole V2 exposes at least part of the second portion 32. The pixel electrode 25 extends into the second via hole V2, and the pixel electrode 25 is in contact with and connected to the second portion 32 through the second via hole V2; that is, the pixel electrode 25 is directly connected to the second portion 32.

In some other embodiments, as shown in FIG. 6, the array substrate 100 further includes a transfer electrode 26. The transfer electrode 26 is located between the active layer ACT and the third insulating layer PVX1, and is electrically connected to the second portion 32. The second via hole V2 also penetrates the fourth insulating layer PVX2, and the second via hole V2 exposes at least part of the transfer electrode 26. The pixel electrode 25 extends into the second via hole V2, and the pixel electrode 25 is in contact with and connected to the transfer electrode 26 through the second via hole V2. That is, the pixel electrode 25 is electrically connected to the second portion 32 through the transfer electrode 26.

The transfer electrode 26 may be located in the same layer as the gate 22 and the gate line GL and include the same material as the gate 22 and the gate line GL; that is, the transfer electrode 26, the gate 22 and the gate line GL are formed by a same patterning process using the same mask and/or the same material. For the material and the thickness of the transfer electrode 26, reference may be made to the material and the thickness of the gate 22 mentioned above, which will not be repeated here.

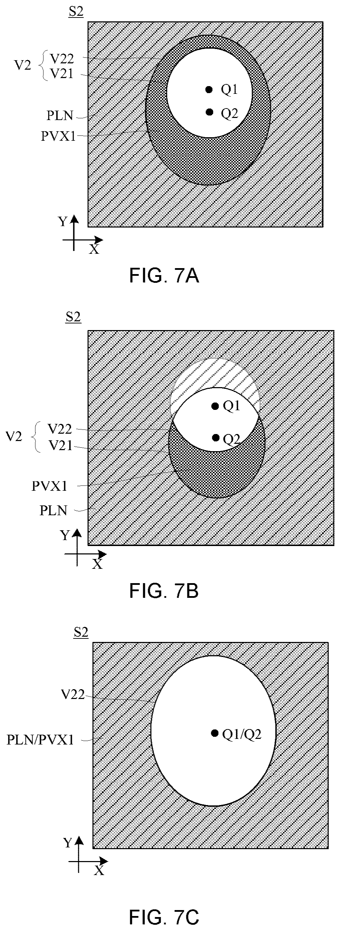

FIGS. 7A to 7D are regarded as partial enlarged views of the third insulating layer PVX1 and the planarization layer PLN in the region S2 in FIG. 3. Referring to FIGS. 4 and 7A, in some embodiments, the second via hole V2 includes a first sub-hole V21 penetrating the third insulating layer PVX1, and a second sub-hole V22 penetrating the planarization layer PLN. An orthogonal projection of the second sub-hole V22 on the base substrate 110 covers an orthogonal projection of the first sub-hole V21 on the base substrate 110, and a center Q1 of the orthogonal projection of the second sub-hole V22 on the base substrate and a center Q2 of the orthogonal projection of the first sub-hole V21 on the base substrate 110 have a spacing therebetween. That is, the first sub-hole V21 and the second sub-hole V22 are arranged non-centrally symmetrically, which is beneficial to reducing the overall area of the orthogonal projection of the second via hole V2 on the base substrate 110, and is beneficial to reducing the area of the black matrix of the opposite substrate (an orthographic projection of the black matrix on the array substrate needs to cover the second via hole to avoid light leakage problems), thereby improving the aperture ratio of the array substrate.

For example, the first sub-hole V21 and the second sub-hole V22 may be formed by adopting two processes respectively when manufacturing the third insulating layer PVX1 and the planarization layer PLN. For example, the manufacturing method of the array substrate may include forming a whole layer of the third insulating layer PVX1, patterning the whole layer of the third insulating layer PVX1 to form a first sub-hole V21, forming a whole layer of the planarization layer PLN on a side of the third insulating layer PVX1 away from the base substrate, and patterning the whole layer of the planarization layer PLN to form a second sub-hole V22, and the second sub-hole V22 exposes the first sub-hole V21.

In some embodiments, referring to FIGS. 3 and 7A, the center Q2 of the orthogonal projection of the second sub-hole V22 on the base substrate 110 is spaced apart from the center Q1 of the orthogonal projection of the first sub-hole V21 on the base substrate 110 in the first direction Y. That is, the center Q2 of the second sub-hole V22 and the center Q1 of the first sub-hole V21 are staggered in the extension direction of the gate line GL, so that the aperture ratio of the array substrate may be greatly improved.

It will be noted that the orthographic projection of the black matrix on the array substrate covers the gate line. Based on this, an orthographic projection of at least part of the black matrix on the array substrate penetrates the array substrate in the first direction Y. The center Q2 of the second sub-hole V22 and the center Q1 of the first sub-hole V21 are staggered in the extension direction of the gate line GL. Thus, the dimension of the black matrix in the second direction X may be reduced without increasing the dimension of the black matrix in the first direction Y, which may greatly reduce the area of the black matrix, thereby improving the aperture ratio of the array substrate.

In an example, as shown in FIG. 7A, the first sub-hole V21 may be completely located within the second sub-hole V22. Alternatively, in some other examples, referring to FIG. 7B, the first sub-hole V21 may be partially located within the second sub-hole V22 and partially located outside the second sub-hole V22.

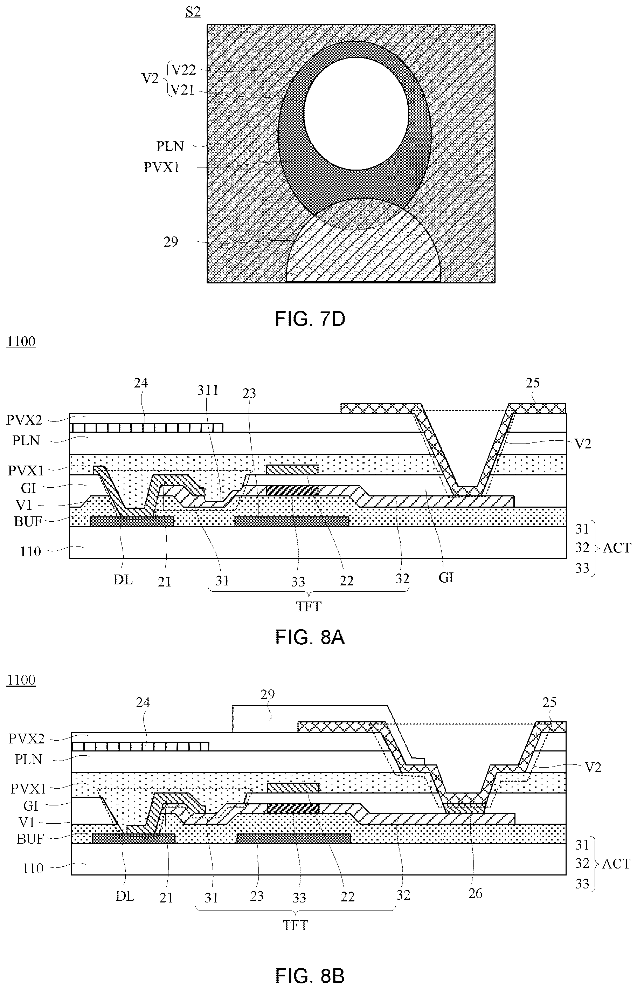

In some other embodiments, referring to FIGS. 7C and 8A, a boundary of the orthogonal projection of the second sub-hole V22 on the base substrate 110 substantially coincides with a boundary of the orthogonal projection of the first sub-hole V21 on the base substrate 110, and the center Q2 of the orthogonal projection of the second sub-hole V22 on the base substrate 110 substantially coincides with the center Q1 of the orthogonal projection of the first sub-hole V21 on the base substrate 110. In this way, the second sub-hole V22 and the first sub-hole V21 may be simultaneously formed by one etching process, that is, the masks for forming the second sub-hole V22 and the first sub-hole V21 are merged, which is beneficial to simplify the manufacturing process of the array substrate and improve the manufacturing efficiency of the array substrate.

For example, the first sub-hole V21 and the second sub-hole V22 may be formed simultaneously by the same process during manufacturing the third insulating layer PVX1 and the planarization layer PLN. For example, the manufacturing method of the array substrate may include: forming a whole layer of the third insulating layer PVX1; forming a whole layer of the planarization layer PLN on the side of the third insulating layer PVX1 away from the base substrate; and patterning the whole layer of the planarization layer PLN and the whole layer of the third insulating layer PVX1 to form the second sub-hole V22 and the first sub-hole V21.

In some embodiments, referring to FIGS. 7D and 8B, the array substrate 100 further includes a supporting block 29, and the supporting block 29 is configured to carry a spacer PS, which is a structure disposed between the array substrate and the opposite substrate for maintaining a stable thickness of the liquid crystal layer. The supporting block 29 is located on a side of the pixel electrode 25 away from the base substrate 110, and an orthographic projection of the supporting block 29 on the base substrate 110 at least partially overlaps with the orthogonal projection of the second sub-hole V2 on the base substrate 110. At least part of the second sub-hole V2 is filled with the supporting block 29.

In some embodiments, the material of the third insulating layer PVX1 may include one or more of silicon oxide, silicon oxynitride, and silicon nitride, or the third insulating layer PVX1 may include an insulating stacked structure. For example, the third insulating layer PVX1 includes silicon oxide and silicon oxynitride that are stacked. The thickness of the third insulating layer PVX1 may be in a range of 200 nm to 400 nm, inclusive. For example, the thickness of the third insulating layer PVX1 is 200 nm, 300 nm, 350 nm, or 400 nm, which is not listed one by one in the embodiments of the present disclosure.

The material of the planarization layer PLN may include an organic insulating material; for example, the material of the planarization layer PLN may include polyimide. In addition, the thickness of the planarization layer PLN may be in a range of 2 µm to 3 µm. For example, the thickness of the planarization layer PLN may be 2 µm, 2.5 µm, 2.8 µm or 3 µm, etc., which will not be listed one by one in the embodiments of the present disclosure.

The material of the common electrode 24 may include, for example, a transparent conductive material, so that the light emitted by the backlight source can pass through the common electrode 24. The transparent conductive material may be, for example, at least one of IGZO and IZO. In addition, the thickness of the common electrode 24 is in a range of 40 nm to 135 nm; for example, the thickness of the common electrode 24 is 40 nm, 80 nm, 100 nm, or 135 nm, which is not listed one by one in the embodiments of the present disclosure.

The material of the pixel electrode 25 may include, for example, a transparent conductive material, so that the light emitted by the backlight source can pass through the pixel electrode 25. The transparent conductive material may be, for example, at least one of ITO and IZO. In addition, the thickness of the common electrode 24 is in a range of 40 nm to 135 nm; for example, the thickness of the common electrode 24 is 40 nm, 80 nm, 100 nm, or 135 nm, which is not listed one by one in the embodiments of the present disclosure. The materials of the common electrode 24 and the pixel electrode 25 may be the same or different, and the thicknesses of the common electrode 24 and the pixel electrode 25 may be the same or different.

For the material of the fourth insulating layer PVX2, reference may be made to the material of the third insulating layer PVX1 mentioned above, which will not be repeated here.

In some embodiments, referring to FIGS. 4, 6, 8A and 8B, the second insulating layer GI extends substantially in the entire array substrate 100. For example, an orthographic projection of the second insulating layer GI on the base substrate 10 is at least partially non-overlapping with the orthographic projections of the gate 22 and the gate line GL on the base substrate 110.

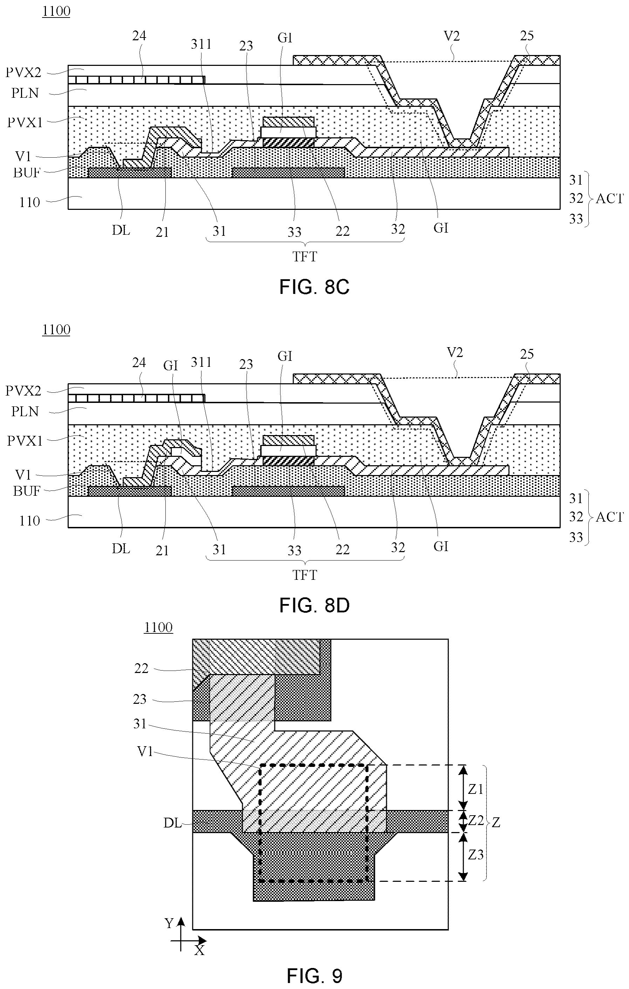

In some other embodiments, referring to FIGS. 8C and 8D, the second insulating layer GI does not substantially extend in the entire array substrate 100. For example, the orthographic projection of the second insulating layer GI on the base substrate 110 substantially coincides with the orthographic projections of the gate 22 and the gate line GL on the base substrate 110.

In some embodiments, referring to FIGS. 3, 4 and 6 and FIGS. 8A to 8D, the array substrate 100 further includes a connection electrode 21, and the connection electrode 21 is located on a side of the active layer ACT away from the base substrate 110. In this case, the first via hole V1 further penetrates the second insulating layer GI. At least part of the connection electrode 21 is located in the first via hole V1, and an orthographic projection of the connection electrode 21 on the base substrate 110 at least partially overlaps with an orthographic projection of the first portion 31 on the base substrate 110, and at least partially overlaps with an orthographic projection of the signal line DL on the base substrate 110. Based on this, the connection electrode 21 may be electrically connected to the signal line DL and the first portion 31 respectively, so that the signal line DL is electrically connected to the first portion 31. That is, the first portion 31 is configured to be electrically connected to the signal line DL through the connection electrode 21, and the first portion 31 is indirectly electrically connected to the signal line DL through the connection electrode 21.

In some embodiments, the connection electrode 21 may be located in the same layer as the gate 22 and include the same material as the gate 22. For example, the connection electrode 21 and the gate 22 are formed by the same patterning process using the same mask and/or the same material. Compared with forming the connection electrode 21 separately, the connection electrode 21 is located in the same layer as the gate 22 and include the same material as the gate 22, which is beneficial to simplifying the manufacturing process of the array substrate. For the material and the thickness of the connection electrode 21, reference may be respectively made to the material and the thickness of the gate 22 mentioned above, which will not be repeated here.

In some embodiments, FIGS. 3, 4, 6, and 8A, the orthographic projection of the first portion 31 on the base substrate 110 at least partially overlaps with the orthographic projection of the signal line DL on the base substrate 10. For example, an orthographic projection of an end (the left end in the figure) of the first portion 31 away from the channel structure 33 on the base substrate 110 is located within the orthographic projection of the signal line DL on the base substrate. Furthermore, at least part of the orthographic projection of the signal line DL on the base substrate 110 in the first via hole V21 is non-overlapping with the orthographic projection of the first portion 31 on the base substrate; that is, the first via hole V1 exposes at least part of the signal line DL.

In some embodiments, referring to FIGS. 8A and 8B, in the case where the second insulating layer GI extends substantially in the entire array substrate 100, within the range of the first via hole V1, the orthographic projection of the connection electrode 21 on the base substrate is non-overlapping with the orthographic projection of the second insulating layer GI on the base substrate.

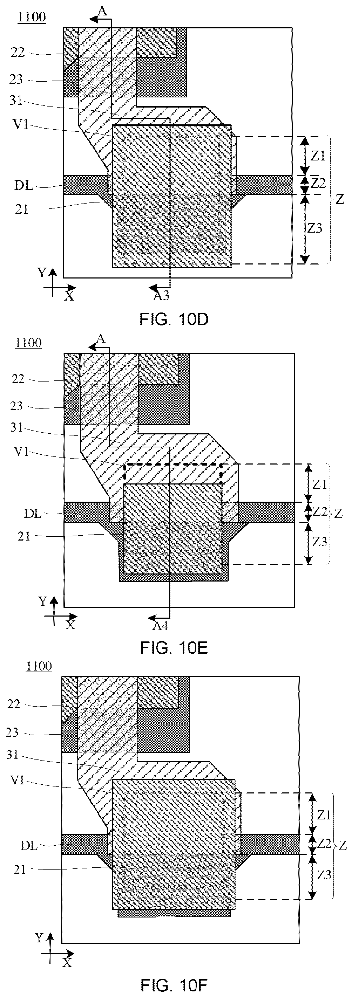

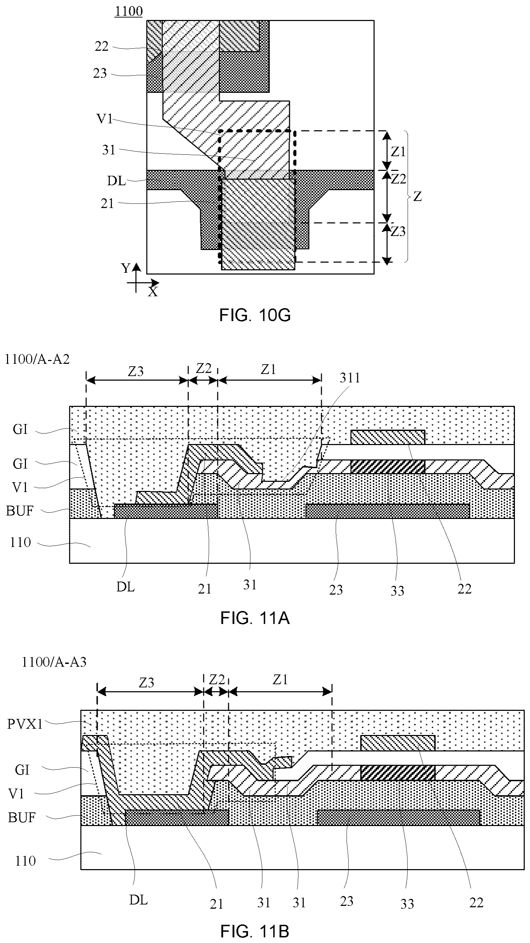

Of course, in some other embodiments, in the case where the connection electrode 21 covers the entire first via hole V1 and at least partially extends beyond the first via hole V1 (as shown in FIGS. 10D and 11B), outside the range of the first via hole V1, the orthographic projection of the connection electrode 21 on the base substrate may also partially overlap with the orthographic projection of the second insulating layer GI on the base substrate.

In some other embodiments, referring to FIGS. 8C and 8D, in the case where the second insulating layer GI does not substantially extend in the entire array substrate 100, within the first via hole V1, referring to FIG. 8C, the orthographic projection of the connection electrode 21 on the base substrate is non-overlapping with the orthographic projection of the second insulating layer GI on the base substrate. Alternatively, referring to FIG. 8D, the orthographic projection of the first connection electrode 21 on the base substrate partially overlaps with the orthographic projection of the second insulating layer GI on the base substrate.

For example, in a case where the second insulating layer GI does not substantially extend in the entire array substrate 100, the manufacturing process of the array substrate may include: forming a whole layer of the second insulating layer GI; patterning the whole layer of the second insulating layer GI to expose at least part of the signal line DL; and forming the connection electrode 21; in this case, the connection electrode is non-overlapping with the second insulating layer GI (the structure shown in FIG. 8C is formed), or the connection electrode partially overlaps with the second insulating layer GI outside the range of the first via hole V1 (the structure shown in FIG. 8D is formed).

In the following embodiments of the present disclosure, the second insulating layer GI shown in the figures substantially extending in the entire array substrate 100 or the second insulating layer GI substantially does not extending in the entire array substrate 100 are only examples, which does not constitute a limitation to the present application. Based on the structure shown in the figures, it may be arbitrarily selected whether the second insulating layer GI extends in the entire array substrate according to needs.

Referring to FIG. 9, FIG. 9 is a partial enlarged view of the region where the first via hole V1. In some embodiments, referring to FIG. 9, the array substrate 100 includes a first connection region Z defined by the first via hole V1, and the first connection region Z includes a first region Z1, a second region Z2, and a third region Z3 that are sequentially connected in a direction away from the channel structure 33.

As shown in FIG. 9, an orthogonal projection of the first region Z1 on the base substrate 110 partially overlaps with the orthographic projection of the first portion 31 on the base substrate 110 and is non-overlapping with the orthographic projection of the signal line DL on the base substrate 110; an orthogonal projection of the second region Z2 on the base substrate 110 partially overlaps with the orthographic projection of the first portion 31 on the base substrate 110 and is located within the orthographic projection of the signal line DL on the base substrate 110; an orthogonal projection of the third region Z3 on the base substrate 110 is located outside the orthographic projection of the first portion 31 on the base substrate 110 and at least partially overlaps with the orthographic projection of the signal line DL on the base substrate 110. That is, in the first direction Y, a boundary of the first region Z1 coincides with the boundary of the first via hole V1, and a lower border of the first region Z1 coincides with the upper border of the signal line DL. An upper border of the second region Z2 coincides with the upper border of the signal line DL, and the lower border of the second region Z2 coincides with the lower border of the first portion 31. An upper border of the third region Z3 coincides with the lower border of the first portion 31, and the lower border of the third region Z3 coincides with the lower border of the first via hole V1.

In some embodiments, the connection electrode 21 covers at least part of the second region Z2 and the third region Z3. In this way, it is possible to ensure that the connection electrode 21 is connected to both the first portion 31 and the signal line DL.

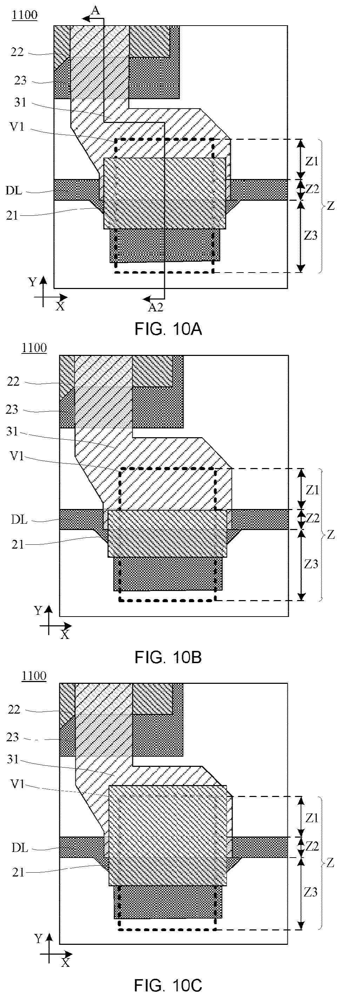

In some embodiments, referring to FIGS. 10A to 10D, a lower border of the orthogonal projection of the first via hole V1 on the base substrate 110 is located outside the orthographic projection of the signal line DL on the base substrate 110.

As shown in FIGS. 10A and 11A, FIG. 11A may be regarded as a sectional structural diagram along the section line A-A2 in FIG. 10A. In the first connection region Z, the connection electrode 21 covers the second region Z2, a part of the third region Z3 proximate to the second region Z2, and a part of the first region Z1 proximate to the second region Z2, and the connection electrode 21 exposes a part of the third region Z3 away from the second region Z2, and a part of the first region Z1 away from the second region Z2.

With continued reference to FIGS. 10A and 11A, in a section (the section shown in FIG. 11A) taken along a plane perpendicular to the base substrate 110, perpendicular to the direction (the second direction X) in which the signal line extends in length, and intersecting the signal line DL and the first via hole V1, at least part of the upper surface of the signal line DL and at least one of the two side surfaces each connected to both the upper surface to the lower surface of the signal line DL are not exposed in the first via hole. The lower surface refers to a surface of the signal line DL that is in contact with the base substrate 110.

Referring to FIG. 11A, in the section shown in FIG. 11A, only the upper surface of the middle portion of the signal line DL is covered by the first portion or the connection electrode 21, and the upper surface of the portion (the left portion) of the signal line DL away from the channel structure 33 is covered by the third insulating layer (not shown in the figure), and the upper surface of the portion of the signal line DL proximate to the channel structure 33 is covered by the first insulating layer BUF. Moreover, one side surface (right side surface) connected to both the upper surface and the lower surface of the signal line DL is covered by the first insulating layer BUF, and the other side surface connected to both the upper surface and the lower surface of the signal line DL is covered by the third insulating layer.

In some embodiments, as shown in FIG. 10B, in the first connection region Z, the connection electrode 21 covers the second region Z2 and a part of the third region Z3 proximate to the second region Z2, and the connection electrode 21 exposes a part of the third region Z3 away from the second region Z2 and the first region Z1.

In some embodiments, as shown in FIG. 10C, in the first connection region Z, the connection electrode 21 covers the second region Z2, a part of the third region Z3 proximate to the second region Z2, and the first region Z1, and the connection electrode 21 exposes a part of the third region Z3 away from the second region Z2.

As shown in FIGS. 10B and 10C, in the case where the connection electrode 21 exposes a part of the third region Z3 away from the second region Z2, in a section (the section as shown in FIG. 11A) along a plane perpendicular to the base substrate 110, perpendicular to the direction (the second direction X) in which the signal line extends in length, and intersecting the signal line DL and the first via hole V1, only the upper surface of the middle portion of the signal line DL is covered by the first portion or the connection electrode 21, and the upper surface of the portion of the signal line DL away from the channel structure 33 is covered by the third insulating layer (not shown in the figure), and the upper surface of the portion proximate to the channel structure 33 is covered by the first insulating layer BUF. Moreover, one side surface (right side surface) connected to both the upper surface and the lower surface of the signal line DL is covered by the first insulating layer BUF, and the other side surface connected to both the upper surface and the lower surface of the signal line DL is covered by the third insulating layer.

It will be noted that in all embodiments of the present disclosure, in the case where the array substrate 100 includes a connection electrode 21, the description "a certain surface of the signal line DL is covered by the first portion 31 or the connection electrode 21" means that a certain surface of the signal line DL is covered by the connection electrode 21. In the case where the array substrate 100 does not include the connection electrode 21 and the first portion 31 is directly connected to the signal line DL, the description "a certain surface of the signal line DL is covered by the first portion 31 or the connection electrode 21" means that a certain surface of the signal line DL is covered by the first portion 31. That is, the description "a certain surface of the signal line DL is covered by the first portion 31 or the connection electrode 21" means that a certain surface of the signal line DL is covered by the first portion 31 or the connection electrode 21 that is in direct contact with the signal line DL.

The term "covered" mentioned herein may refer to the positional relationship of film layers in space, or may refer to the positional relationship between the orthographic projections of film layers on the base substrate.

In some embodiments, as shown in FIGS. 10D and 10E, in the first connection region Z, the connection electrode 21 covers the second region Z2, the third region Z3, and at least part of the first region Z1. For example, as shown in FIG. 10D, the connection electrode 21 covers the entire first region Z1; alternatively, as shown in FIG. 10E, the connection electrode 21 covers a part of the first region Z1.

Referring to FIG. 11B, in a case where the orthographic projection of the first via hole V1 on the base substrate 110 is located within the orthographic projection of the signal line DL on the base substrate 110, and the connection electrode 21 covers the third region Z3, in a section (the section shown in FIG. 11B) taken along a plane perpendicular to the base substrate 110, perpendicular to the direction (the second direction X) in which the signal line extends in length, and intersecting the signal line DL and the first via hole V1, the upper surface of the portion of the signal line DL away from the channel structure 33 is covered by the third insulating layer PVX1, and the upper surface of the portion of the signal line DL proximate to the channel structure 33 is covered by the first insulating layer BUF. Moreover, one side surface (right side surface) connected to both the upper surface and the lower surface of the signal line DL is covered by the first insulating layer BUF, and the other side surface (left side surface) connected to both the upper surface and the lower surface of the signal line DL is covered by the third insulating layer PVX1.

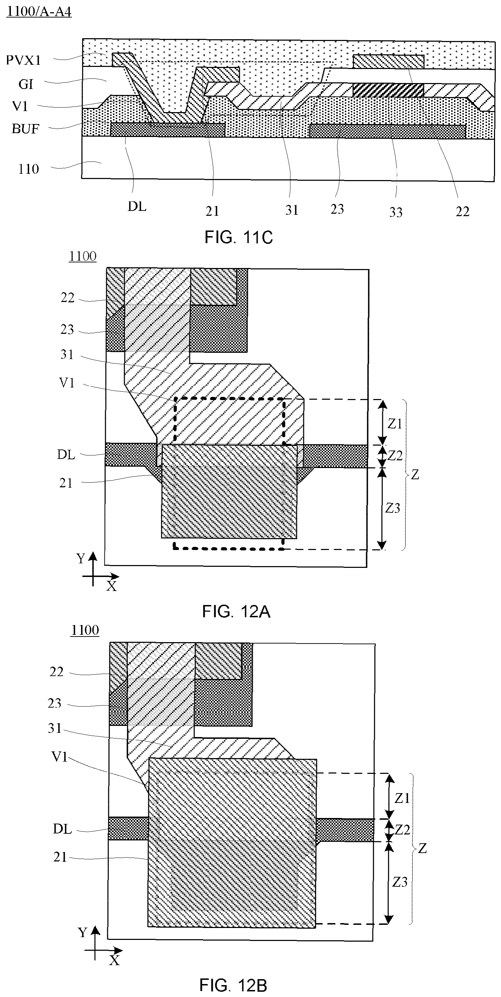

Referring to FIG. 11C, in a case where at least part of the orthographic projection of the first via hole V1 on the base substrate 110 is located on a side of the orthographic projection of the signal line DL on the base substrate 110 away from the channel structure 33, and the connection electrode 21 covers the third region Z3, in a section (the section shown in FIG. 11C) taken along a plane perpendicular to the base substrate 110, perpendicular to the direction (the second direction X) in which the signal line extends in length, and intersecting the signal line DL and the first via hole V1, the upper surface of the portion of the signal line DL away from the channel structure 33 (the upper surface of the portion away from the channel structure 33) is covered by the connection electrode 21, and the upper surface of the portion proximate to the channel structure 33 is covered by the first insulating layer BUF. Moreover, one side surface (right side surface) of the signal line DL connected to both the upper surface and the lower surface is covered by the first insulating layer BUF, and the other side surface (left side surface) of the signal line DL connected to both the upper surface and the lower surface is covered by the connection electrode 21.

Referring to FIGS. 10E and 10F, an orthographic projection of the lower border of the first via hole V1 on the base substrate 110 is located within the orthographic projection of the signal line DL on the base substrate 110.

In some embodiments, referring to FIG. 10E, in the first connection region Z, the connection electrode 21 covers the second region Z2, the third region Z3, and a part of the first region Z1 proximate to the second region Z2, and the connection electrode 21 exposes a part of the first region Z1 away from the second region Z2.

In some embodiments, referring to FIG. 10F, in the first connection region Z, the connection electrode 21 covers the second region Z2, the third region Z3, and the first region Z1.

In some embodiments, as shown in FIGS. 10E and 10F, the orthographic projection of the lower border of the first via hole V1 on the base substrate 110 is within the orthographic projection of the signal line DL on the base substrate 110, and the connection electrode 21 covers the third region Z3, referring to FIG. 11C, in the section (the section shown in FIG. 11C) taken along a plane perpendicular to the base substrate 110, perpendicular to the direction (the second direction X) in which the signal line extends in length, and intersecting the signal line DL and the first via hole V1, only the upper surface of the middle portion of the signal line DL is exposed in the first via hole V1, and the two side surfaces each connected to both the upper surface and the lower surface of the signal line DL are covered by the first insulating layer BUF. In this case, the upper surface of the portion of the signal line DL exposed by the first via hole V1 is covered by the connection electrode 21, and the upper surface of the portion of the signal line DL not exposed by the first via hole V1 is covered by the first insulating layer BUF.

FIG. 10G is a plan view of an array substrate, in accordance with some embodiments of the present disclosure; FIG. 11C may also be viewed as a sectional view of FIG. 10G. Referring to FIGS. 10G and 11C, in some embodiments, in a section (e.g., the section shown in FIG. 11C) taken along a plane perpendicular to the base substrate 110, perpendicular to the direction Y in which the signal line DL extend in length, and intersecting the signal line DL and the first via hole V1, at least a portion of the signal line DL is covered by the first insulating layer BUF, and at least a portion of the upper surface of the signal line DL is not exposed in the first via hole V1. For example, in the section shown in FIG. 11C, a first portion of the signal line DL is not covered by the first insulating layer BUF, and a second portion of the signal line DL is covered by the first insulating layer BUF. In the section shown in FIG. 11C, the upper surface of the first portion of the signal line DL is exposed by the first via hole V1, and the upper surface of the second portion of the signal line DL is not exposed in the first via hole V1. The first portion is located on a side of the second portion away from the channel structure 33.

In the section shown in FIG. 11C, the upper surface of the signal line DL is partially covered by the connection electrode 21 and partially covered by the first insulating layer BUF. In an example, in the section shown in FIG. 11C, the upper surface of the first portion of the signal line DL is covered by the connection electrode 21, and the upper surface of the second portion of the signal line DL is covered by the first insulating layer BUF. The first portion is located on a side of the second portion away from the channel structure 33.

In an example, in the section shown in FIG. 11B, a first side surface of the signal line DL is covered by the connection electrode 21, and a second side surface of the signal line DL is covered by the first insulating layer BUF. The first side surface is located on a side of the second side surface away from the channel structure 33.

Referring to FIGS. 10G and 11C, in some embodiments, in a section (e.g., the section shown in FIG. 11C) taken along a plane perpendicular to the base substrate 110, perpendicular to the direction (the second direction X) in which the signal line extends in length, and intersects the signal line DL and the first via hole V1, at least a portion of the signal line DL is covered by the first insulating layer BUF, and at least a portion of the upper surface of the signal line DL is not exposed in the first via hole V1. For example, in the section shown in FIG. 11C, the middle portion of the signal line DL is not covered by the first insulating layer BUF, and portions of the signal line DL at two sides are covered by the first insulating layer BUF. In the section shown in FIG. 11C, the upper surface of the middle portion of the signal line DL is exposed by the first via hole V1, and the upper surfaces of portions of the signal line DL at two sides are not exposed in the first via hole V1.

In the section shown in FIG. 11C, the upper surface of the signal line DL is partially covered by the connection electrode 21 and partially covered by the first insulating layer BUF. In an example, in the section shown in FIG. 11C, the upper surface of the middle portion of the signal line DL is covered by the connection electrode 21, and the upper surfaces of the portions of the signal line DL at two sides are covered by the first insulating layer BUF. In an example, in the section shown in FIG. 11C, both two side surfaces of the signal line DL are covered by the first insulating layer BUF.

In some embodiments, referring to FIGS. 10A to 10D and FIG. 10F, the maximum width of the connection electrode 21 in the second direction X is greater than the maximum width of the first portion 31 in the second direction X.

In some other embodiments, referring to FIGS. 10E and 10G, the maximum width of the connection electrode 21 in the second direction X is less than or equal to the maximum width of the first portion 31 in the second direction X.

In some embodiments, referring to FIG. 10D, the connection electrode 21 crosses the signal line DL. The orthographic projection of the connection electrode 21 on the base substrate 110 overlaps with the orthographic projection of the signal line DL on the base substrate 110. For example, as shown in FIG. 10D, the maximum width of the connection electrode 21 in the first direction Y is greater than the maximum width of the first portion 31 in the first direction Y.

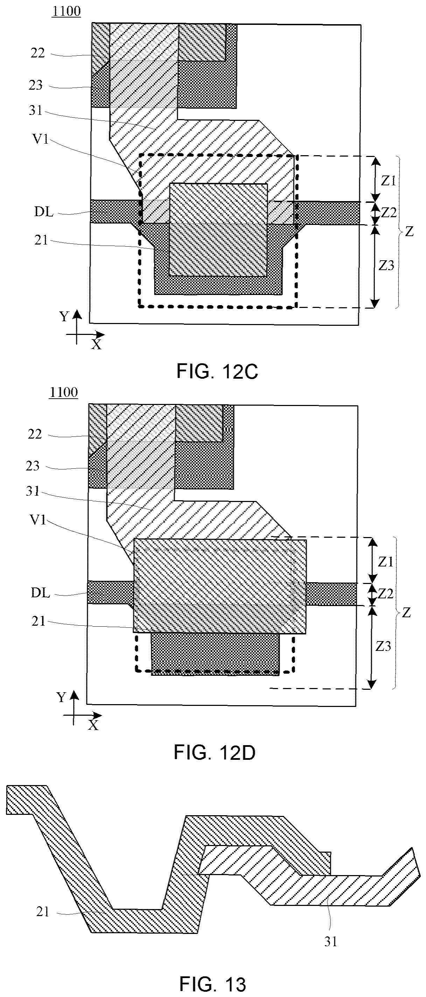

The connection electrode 21 may be arranged at various positions with respect to the first portion 31, the signal line DL, and the first via hole V1. FIGS. 10A to 10G and FIGS. 12A to 12D illustrate various arrangements of the connection electrode 21 in an array substrate relative to adjacent components according to some embodiments of the present disclosure. The orthographic projection of the connection electrode 21 on the base substrate partially overlaps with the orthographic projection of the first portion 31 on the base substrate, and partially overlaps with the orthographic projection of the signal line DL on the base substrate. The orthogonal projection of the first via hole V1 on the base substrate partially overlaps with the orthographic projection of the first portion 31 on the base substrate, and partially overlaps with the orthographic projection of the signal line DL on the base substrate. It may be understood that the embodiments of the present disclosure are not exhaustive, as long as the same technical concept is adopted.

In some embodiments, referring to FIGS. 11A to 11C, in the first region Z1, the array substrate 100 includes at least the first insulating layer BUF and the first portion 31 that are stacked; in the case where the connection electrode 21 covers at least part of the first region Z1, the first region Z1 further includes the connection electrode 21 disposed on a side of the first portion 31 away from the base substrate 110. In the second region Z2, the array substrate 100 includes the signal line DL, the first insulating layer BUF, the first portion 31, and the connection electrode 21 that are stacked. In the third region Z3, the array substrate 100 includes at least the signal line DL and the connection electrode 21 that are stacked.

Based on the above stacked structure in the first region Z1, referring to FIGS. 11A to 11C, the signal line DL, the first insulating layer BUF, the first portion 31 and the connection electrode 21 may form a protruding structure in the second region Z2 relative to the first region Z1 and the third region Z3. In other words, referring to FIGS. 11A to 11C, the third insulating layer PVX1 covers the first connection region Z, and the third insulating layer PVX1 includes a first surface 27 located on a side proximate to the base substrate 110, and a portion of the first surface 27 located in the second region Z2 protrudes toward a side (upper side) away from the base substrate 110 relative to portions of the first surface 27 located in the first region Z1 and the third region Z3 to form a protruding structure.

In some embodiments, referring to FIG. 10D, FIG. 11B and FIG. 13, FIG. 13 may be considered as a structural diagram of the connection electrode 21 and the first portion 31 in FIG. 11B. Part of the first portion 31 extends onto the connection electrode 21.

For example, in the process of patterning the second insulating layer GI to form the first via hole 31, part of the first insulating layer BUF located on the side of the first portion 31 proximate to the base substrate 110 is removed, and an end of the first portion 31 away from the channel structure 33 forms a suspended structure. Then, in the process of forming the connection electrode 21, the connection electrode 21 fills the region of the removed portion of the first insulating layer BUF, and the connection electrode 21 covers the suspended portion of the first portion 31, forming the structure as shown in FIG. 13 in which part of the first portion 31 extends onto the connection electrode 21.

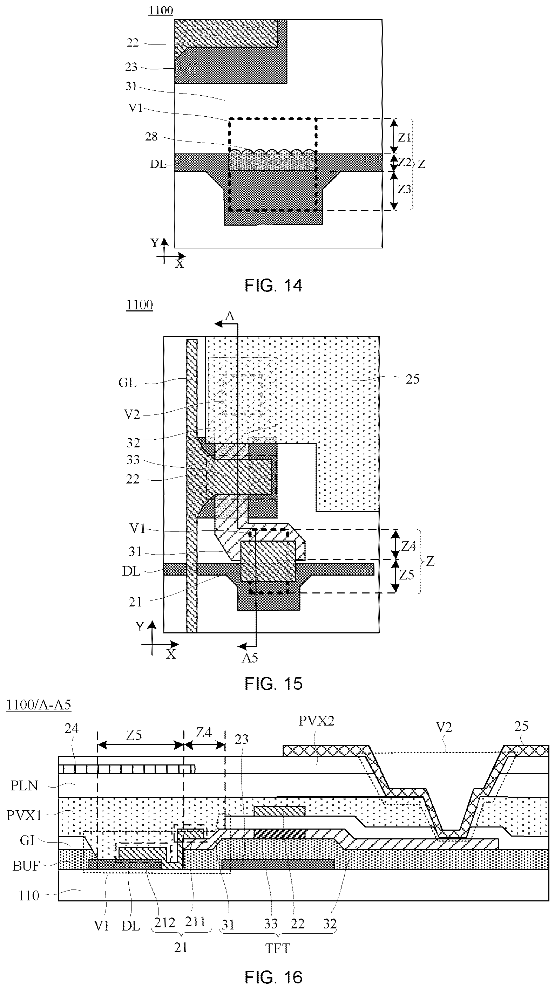

In some embodiments, referring to FIG. 14, an edge of the second region Z2 proximate to the first zone Z1 includes a plurality of irregular undulating structures, which is similar to a zigzag structure 28. The first insulating layer BUF has an undulating structure at the boundary of the signal line DL, and thus at least one of the film layers substantially disposed in the second region Z2 proximate to the first region Z1 includes a zigzag structure 28. For example, the edge of the first portion 31 in the second region Z2 proximate to the first region Z1 may be in a shape of a zigzag, and/or the edge of the connection electrode 21 in the second region Z2 proximate to the first region Z1 may be in a shape of a zigzag. It will be noted that FIG. 14 is only used to show the morphology of the zigzag structure, and does not specifically refer to a certain film layer. For example, the zigzag structure shown in FIG. 14 may be located on the first portion 31 and/or the connection electrode 32.

In some embodiments, referring to FIGS. 4, 6, 8A and 11A, in the case where the connection electrode 21 exposes at least part of the first region, i.e., the connection electrode 21 exposes at least part of the first portion 31 in the first via hole V1, the first portion 31 includes a groove 311 that is recessed toward the base substrate 110. The groove 311 is located in the first region, and an orthographic projection of the groove 311 on the base substrate 110 is non-overlapping with the orthographic projection of the connection electrode 21 on the base substrate 110. In other words, the part of the first portion 31 that is located in the first via hole V1 and exposed by the connection electrode 21 forms the groove 311. For example, in the patterning process to form the gate 22 and the gate line GL, at least part of the first portion 31 in the first via hole V1 and exposed by the connection electrode 21 may be removed, thereby forming the groove 311.

In some embodiments, referring to FIG. 15, the orthographic projection of the first portion 31 on the base substrate 110 is non-overlapping with the orthographic projection of the signal line DL on the base substrate 110. For example, an orthographic projection of an end (left end in the figure) of the first portion 31 away from the channel structure 33 on the base substrate 110 and the orthographic projection of the signal line DL on the base substrate 110 have a spacing therebetween.

Referring to FIGS. 15 and 16 , the array substrate 100 includes a first connection region Z defined by the first via hole V1, and the first connection region Z includes a fourth region Z4 and a fifth region Z5 sequentially connected in a direction away from the channel structure 33.

An orthogonal projection of the fourth region Z4 on the base substrate 110 at least partially overlaps with the orthographic projection of the first portion 31 on the base substrate 110, and is non-overlapping with the orthographic projection of the signal line DL on the base substrate 110. An orthogonal projection of the fifth region Z5 on the base substrate 110 at least partially overlaps with the orthographic projection of the signal line DL on the base substrate 110, and is non-overlapping with the orthographic projection of the first portion 31 on the base substrate 110. For example, the fourth region Z4 and the fifth region Z5 are demarcated by the border of the signal line DL, that is, the lower border of the fourth region Z4 coincides with the upper border of the signal line DL, and the upper border of the fifth region Z5 coincides with the upper border of the signal line DL.

The connection electrode 21 covers at least part of the fourth region Z4 and at least part of the fifth region Z5, so that the connection electrode 21 may be connected to both the signal line DL and the connection electrode 21, and in turn the signal line DL is electrically connected to the connection electrode 21.

For example, referring to FIGS. 15 and 16, the connection electrode 21 covers part of the fourth region Z4 and part of the fifth region Z5, and exposes part of the fourth region Z4 and part of the fifth region Z5.

In some embodiments, referring to FIG. 15, the border (the lower border in FIG. 15) of the orthogonal projection of the first via hole V1 on the base substrate away from the channel structure is located within the range of the signal line DL. Referring to FIG. 16, in a section (the section shown in FIG. 16) taken along a plane perpendicular to the base substrate 110, perpendicular to the direction (the second direction X) in which the signal line extends in length, and intersecting the signal line DL and the first via hole V1, at least part of the upper surface of the signal line DL and at least one of the two side surfaces each connected to both the upper surface and the lower surface of the signal line DL are not exposed in the first via hole V1. The lower surface refers to a surface of the signal line DL that is in contact with the base substrate 110.

For example, as shown in FIG. 16, the right portion of the upper surface of the signal line DL is exposed in the first via hole V1, and a first side surface of the two side surfaces each connected to both the upper surface and the lower surface of the signal line DL is exposed in the first via hole V1. The left portion of the upper surface of the signal line DL is not exposed in the first via hole V1, and a second side surface of the two side surfaces is not exposed in the first via hole V1. The first side surface is located on a side of the second side surface proximate to the channel structure.

In some embodiments, as shown in FIG. 16, in the section, the left portion of the upper surface of the signal line DL and one (the left side surface) of the two side surfaces each connected to both the upper surface and the lower surface of the signal line DL are covered by the first insulating layer BUF. For example, as shown in FIG. 16, only the upper surface of a portion of the signal line DL and one side surface (right side surface) of two side surfaces each connected to both the upper surface and the lower surface of the signal line are covered by the connection electrode 21.

In some embodiments, as shown in FIGS. 15 and 16, the connection electrode 21 may cover part of the fifth region Z5 and expose part of the fifth region Z5, so that the connection electrode 21 may cover part of the upper surface of the signal line DL exposed in the first via hole V1 and does not cover another part of the upper surface of the signal line DL exposed in the first via hole V1. For example, for the upper surface of the signal line DL exposed in the first via hole V1, a part proximate to the channel structure 33 is covered by the connection electrode 21, and another part away from the channel structure 33 is covered by the first insulating layer BUF.

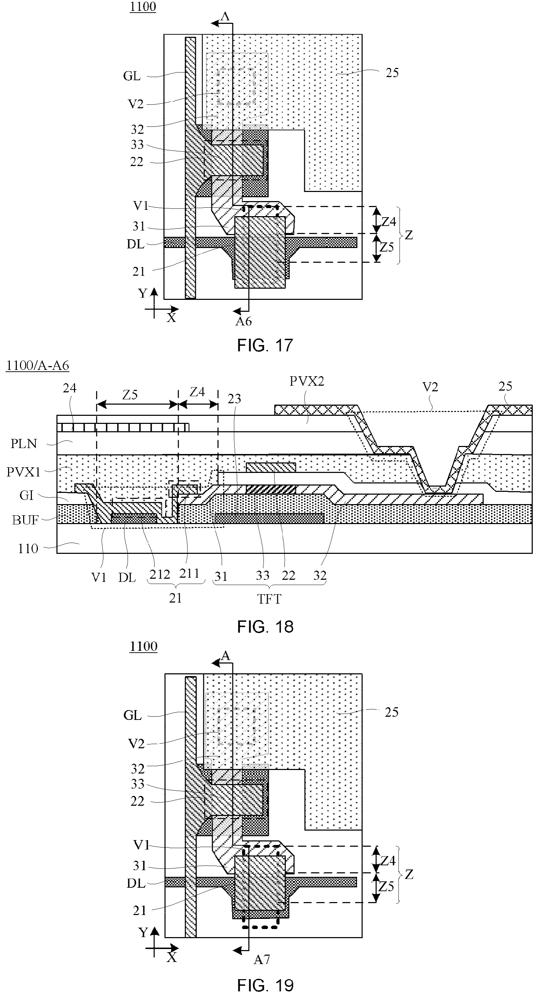

In some embodiments, referring to FIGS. 17 and 18, in the section (the section shown in FIG. 18) taken along a plane perpendicular to the base substrate 110, perpendicular to the direction (the second direction X) in which the signal line extends in length, and intersecting the signal line DL and the first via hole V1, the surfaces of the signal line DL except the lower surface are exposed in the first via hole V1; the lower surface refers to the surface of the signal line DL that is in contact with the base substrate 110.

In some embodiments, referring to FIGS. 17 and 18, the upper surface of the signal line DL and the two side surfaces each connected to both the upper surface and the lower surface of the signal line are completely covered by the connection electrode 21. The connection electrode 21 may cover the fifth region Z5, that is, the connection electrode 21 covers a portion of the signal line DL exposed by the first via hole V1. For example, in the section shown in FIG. 18, only a portion of the upper surface of the signal line DL and only one side surface (right side surface) of two side surfaces each connected to both the upper surface and the lower surface of the signal line are covered by the connection electrode 21.

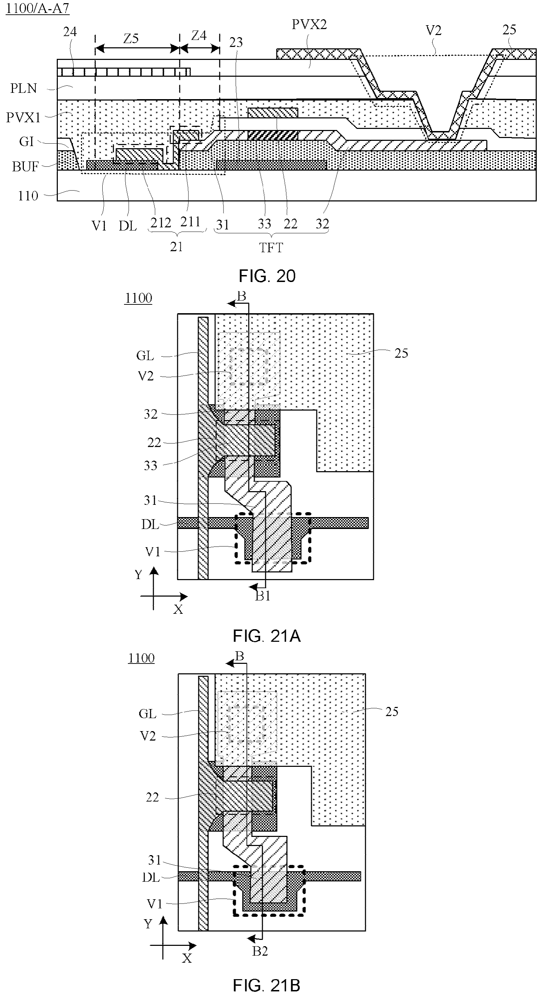

In some embodiments, referring to FIGS. 19 and 20, in a section (the section shown in FIG. 20) taken along a plane perpendicular to the base substrate 110, perpendicular to the direction (the second direction X) in which the signal line extends in length, and intersecting the signal line DL and the first via hole V1, the surfaces of the signal line DL except the lower surface are exposed in the first via hole V1; the lower surface refers to the surface of the signal line DL that is in contact with the base substrate 110.

In some embodiments, the connection electrode 21 may cover a part of the fifth region Z5 and expose another part of the fifth region Z5, so that the connection electrode 21 may cover part of the surfaces of the signal line DL exposed in the first via hole V1 and not cover part of the surfaces of the signal line DL exposed in the first via hole V1.

For example, in the section shown in FIG. 20, the surfaces of the signal line DL are all exposed in the first via holes V1. A portion of the upper surface of the signal line DL proximate to the channel structure 33 is covered by the connection electrode 21, and a portion of the upper surface of the signal line DL away from the channel structure 33 is covered by the third insulating layer PVX1. One side surface (right side surface) of two side surfaces each connected to both the upper surface and the lower surface of the signal line is covered by the connection electrode 21, and the other side surface (left side surface) is covered by the third insulating layer PVX1.

In the embodiments of the present disclosure, as shown in FIGS. 15, 17 and 19, the connection electrode 21 and the first via hole V1 may be arranged at various positions relative to the signal line DL and the first portion 31. Of course, the embodiments of the present disclosure are not limited to this, and any other suitable arrangement positions may be considered as long as the same technical ideas are adopted.

In some embodiments, referring to FIGS. 16 and 18, the connection electrode 21 exposes at least part of the fourth region Z4. The first portion 31 includes a groove 311 that is recessed toward the base substrate 110. The groove 311 is located in the fourth region Z4, and an orthographic projection of the groove 311 on the base substrate 110 is non-overlapping with the orthographic projection of the connection electrode 21 on the base substrate 110. In other words, the first portion 31 located in the first via hole V1 and exposed by the connection electrode 21 forms the groove 311. For example, in the process of patterning the gate 22 and the gate line GL, at least a portion of the first portion 31 in the first via hole V1 and exposed by the connection electrode 21 may be removed to form the groove 311.

Of course, in some other embodiments, referring to FIG. 20, in the case where the connection electrode 21 exposes at least part of the fourth region Z4, the first portion 31 may not form the groove 311.

In some embodiments, referring to FIGS. 16, 18 and 20, in the fourth region Z4, the array substrate 100 includes a first insulating layer BUF, a first portion 31 and a connection electrode 21 that are stacked. In the fifth region Z5, the array substrate 100 includes the signal line DL and the connection electrode 21 that are stacked.

With continued reference to FIGS. 16, 18 and 20, the connection electrode 21 includes a step structure. The step structure includes a first step 211 located in the fourth region Z4 and a second step 212 located in the fifth region Z5. The first step 211 is farther away from the base substrate 110 than the second step 212; that is, a distance between the connection electrode 21 and the base substrate 110 in the fourth region Z4 is greater than a distance between the connection electrode 21 and the base substrate 110 in the fifth region Z5, thereby forming the above-mentioned step structure at the boundary of the fourth region Z4 and the fifth region Z5.

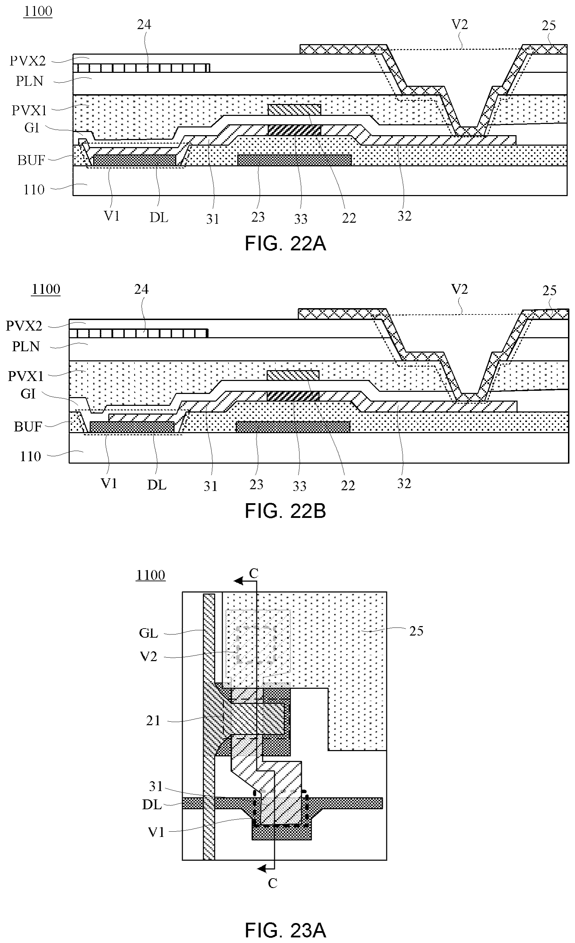

FIG. 21A is a plane view of an array substrate, in accordance with some embodiments of the present disclosure; FIG. 22A is a sectional view of an array substrate, in accordance with some embodiments of the present disclosure; FIG. 22A is regarded as a sectional view taken along the section line B-B1 in FIG. 21A.

In some other embodiments, referring to FIGS. 21A and 22A, the first via hole V1 only penetrates the first insulating layer BUF, at least part of the first portion 31 is located in the first via hole V1, and the first portion 31 is in contact with and connected to the signal line DL through the first via hole BV1. That is, the array substrate does not include the connection electrode 21, and the first portion 31 is directly electrically connected to the signal line DL.

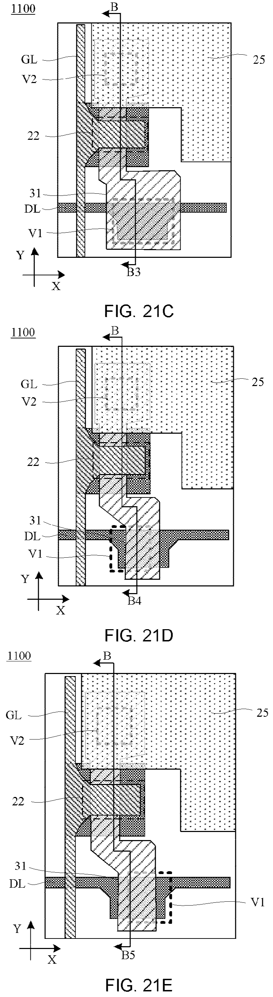

In some embodiments, referring to FIGS. 21Aand 22A, in the case where the first portion 31 is directly electrically connected to the signal line DL, in a section (e.g., the section shown in FIG. 7A) taken along a plane perpendicular to the base substrate 110, perpendicular to the direction (second direction Y) in which the signal line DL extends in length, and intersecting the signal line DL and the first via hole V1, the surfaces of the signal line DL except the surface in contact with the base substrate 110 are exposed in the first via hole V1. For example, in the section, the upper surface of the signal line DL and two side surfaces each connected to both the upper surface and the lower surface of the signal line DL are completely exposed in the first via hole V1. The lower surface is a surface of the signal line DL that is in contact with the base substrate 110.

Referring to FIGS. 21A and 22A, in the section taken along a plane (e.g., the section shown in FIG. 22A) perpendicular to the base substrate 110, perpendicular to the direction Y in which the signal line DL extends in length, and intersecting the signal line DL and the first via V1, the surfaces of the signal line DL except the surface in contact with the base substrate 110 are covered by the first portion 31. For example, in the section shown in FIG. 22A, the upper surface of the signal line DL and two side surfaces each connected to both the upper surface and the lower surface of the signal line DL are completely covered by the first portion 31.

In some embodiments, referring to FIG. 21A, the first portion 31 crosses the signal line DL. An orthographic projection of the first portion 31 on the base substrate intersects with an orthographic projection of the signal line DL on the base substrate.

FIG. 21B is a plane view of an array substrate, in accordance with some embodiments of the present disclosure; FIG. 22B is a sectional view of an array substrate, in accordance with some embodiments of the present disclosure; FIG. 22B is regarded as a sectional view taken along the section line B-B2 shown in FIG. 21B.

Referring to FIGS. 21B and 22B, in some embodiments, the array substrate 100 includes a first via hole V1 penetrating the first insulating layer BUF. Part of the first portion 31 extends into the first via hole V1 and is connected to the signal line DL. For example, the first portion 31 extends through the first via hole V1 to be connected to the signal line DL.

In some embodiments, referring to FIGS. 21B and 22B, in a section (the section shown in FIG. 22B) taken along a plane perpendicular to the base substrate 110, perpendicular to the direction Y in which the signal line extends in length, and intersecting the signal line DL and the first via hole V1, the surfaces of the signal line DL except the surface in contact with the base substrate 110 are exposed in the first via hole V1. For example, in the section shown in FIG. 22B, the upper surface of the signal line DL and two side surfaces each connected to both the upper surface and the lower surface of the signal line DL are completely exposed in the first via hole V1.

In some embodiments, referring to FIGS. 21B and 22B, in a section (the section shown in FIG. 22B) taken along a plane perpendicular to the base substrate 110, perpendicular to the direction Y in which the signal line extends in length, and intersecting the signal line DL and the first via hole V1, the surfaces of the signal line DL except the surface in contact with the base substrate 110 are only partially covered by the first portion 31. For example, in the section shown in FIG. 22B, only a part of the upper surface of the signal line DL and only one of two side surfaces each connected to both the upper surface and the lower surface of the signal line DL are covered by the first portion 31.

In some embodiments, referring to FIG. 21B, the orthographic projection of an end of only part of the first portion 31 in the first direction Y on the base substrate is within the orthographic projection of the signal line DL on the base substrate; for example, the lower end of the first portion 31 does not extend out of the edge of the signal line DL.

Referring to FIGS. 21A and 21B, in some embodiments, the orthographic projection of the first portion 31 on the base substrate only partially overlaps with the orthogonal projection of the first via hole V1 on the base substrate. For example, for the first portion 31 and the first via hole V1, the orthographic projection of part of the first portion 31 on the base substrate and the first via hole V1 is located within the orthogonal projection of the first via hole V1 on the base substrate, and at least part of the first via hole V1 is not filled with the first portion 31.

Referring to FIG. 21A, in some embodiments, the orthographic projection of the first portion 31 on the base substrate overlaps with the orthogonal projection of the middle part of the first via hole V1 on the base substrate, is non-overlapping with the orthogonal projection of the upper part of the first via hole V1 on the base substrate, and is non-overlapping with the orthogonal projection of the lower part of the first via hole V1 on the base substrate. The upper part, the middle part and the lower part are sequentially arranged in the length direction Y of the signal line DL.

FIG. 21C is a plane view of an array substrate, in accordance with some embodiments of the present disclosure. FIG. 22A may also be viewed as a sectional view along the section line B-B3 in FIG. 21C. Referring to FIGS. 21C and 22A, in some embodiments, the orthographic projection of the first portion 31 on the base substrate 110 completely covers the orthogonal projection of the first via hole V1 on the base substrate 110.

FIG. 21D is a plane view of an array substrate, in accordance with some embodiments of the present disclosure. FIG. 22A may also be viewed as a sectional view along the section line B-B4 in FIG. 21D. Referring to FIGS. 21D and 22A, in some embodiments, the orthographic projection of the first portion 31 on the base substrate 110 overlaps with the orthogonal projection of the upper part (the part away from the channel structure 33) of the first via hole V1 on the base substrate 110, and is non-overlapping with the orthogonal projection of the lower part (the part proximate to the channel structure 33) of the first via hole V1 on the base substrate 110. The upper part and the lower part are sequentially arranged in the length direction Y of the gate line GL.

FIG. 21E is a plane view of an array substrate, in accordance with some embodiments of the present disclosure. FIG. 22A may also be viewed as a sectional view along the section line B-B5 in FIG. 21E. Referring to FIGS. 21E and 22A, in some embodiments, the orthographic projection of the first portion 31 on the base substrate 110 overlaps with the orthogonal projection of the lower part (the part away from the channel structure 33) of the first via hole V1 on the base substrate, and is non-overlapping with the orthogonal projection of the upper part (the part proximate to the channel structure 33) of the first via hole V1 on the base substrate. The upper part and the lower part are sequentially arranged in the length direction Y of the signal line DL.

Referring to FIGS. 21A to 21E, in some embodiments, the array substrate 100 further includes a gate line GL. In some embodiments, the gate line GL is a gate line configured to provide a gate driving signal for the thin film transistor. In some embodiments, the gate line GL is connected to the gate 22. For example, the gate line GL and the gate 22 are located in the same layer and include the same material, and the gate line GL and the gate 22 are of a one piece structure. The gate 22 may be regarded as a branch structure of the gate line GL extending outward (perpendicular to the extension direction X of the gate line GL).

In some embodiments, referring to FIGS. 22A and 22B, the array substrate 100 further includes a light shielding component 23 located on the base substrate 110 and a gate line GL located on a side of the light shielding component 23 away from the base substrate 110. Referring to FIGS. 21A to 21E, in the direction X in which the signal line DL extends in length, a ratio of the line width of the gate line GL to the line width of the light shielding component 23 is in a range of 0.3 to 0.9. For example, the ratio of the line width of the gate line GL to the line width of the light shielding component 23 is in a range of 0.3 to 0.4, 0.4 to 0.5, 0.5 to 0.6, 0.6 to 0.7, 0.7 to 0.8, or 0.8 to 0.9. The inventors of the present disclosure have found that, through such a layout, it is possible to ensure light shielding to maintain the aperture ratio of the array substrate, and avoid a short circuit between the gate line GL and the light shielding component 23.

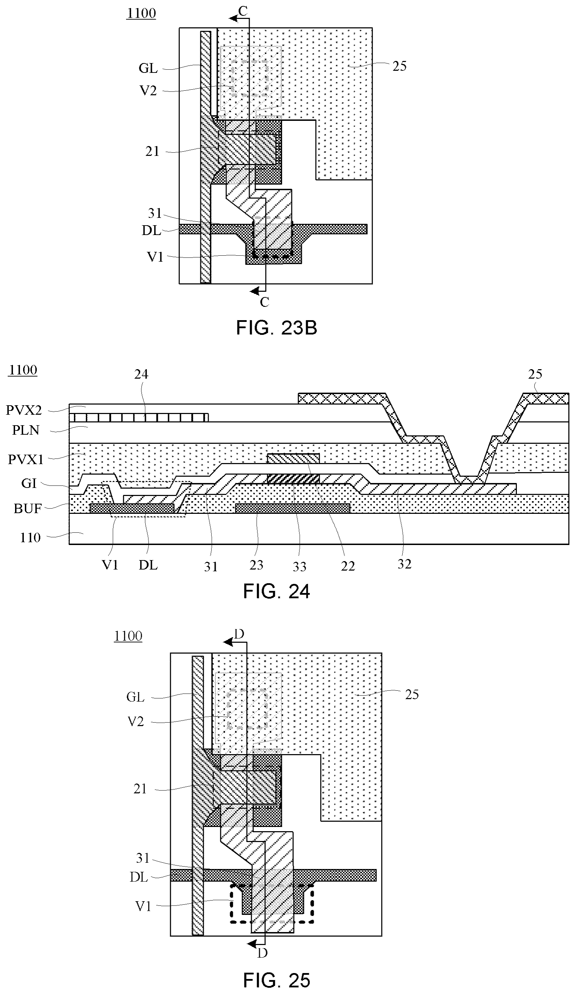

FIG. 23A is a plane view of an array substrate, in accordance with some embodiments of the present disclosure; FIG. 23B is a plane view of an array substrate, in accordance with some embodiments of the present disclosure. FIG. 24 is a sectional view of an array substrate, in accordance with some embodiments of the present disclosure. FIG. 24 is a sectional view taken along the section line C-C in FIG. 23A or taken along the section line C-C in FIG. 23B.

Referring to FIGS. 23A, 23B and 24, in some embodiments, in a section (e.g., the section shown in FIG. 24) taken along a plane perpendicular to the base substrate 110, perpendicular to the direction Y in which the signal line DL extends in length and intersecting the signal line DL and the first via hole V1, at least part of the signal line DL is covered by the first insulating layer BUF, and at least part of the upper surface of the signal line DL is not exposed in the first via hole V1. For example, in the section shown in FIG. 24, a first portion of the signal line DL is covered by the first insulating layer BUF, and a second portion of the signal line DL is not covered by the first insulating layer BUF. In the section shown in FIG. 24, the upper surface of the first portion of the signal line DL is not exposed in the first via hole V1, and the upper surface of the second portion of the signal line DL is exposed by the first via hole V1. The first portion is located on a side (left side) of the second portion away from the channel structure 33.

In some embodiments, referring to FIGS. 23A, 23B and 24, in a section (e.g., the section shown in FIG. 24) taken along a plane perpendicular to the base substrate 110, perpendicular to the direction Y of the signal line DL extends in length, and intersecting the signal line DL and the first via hole V1, the surfaces of the signal line DL except the surface in contact with the base substrate 110 are only partially covered by the first portion 31. For example, in the section shown in FIG. 24, only an upper surface of a part of the signal line DL and only one of two side surfaces each connected to both the upper surface and the lower surface of the signal line DL are covered by the first portion 31.

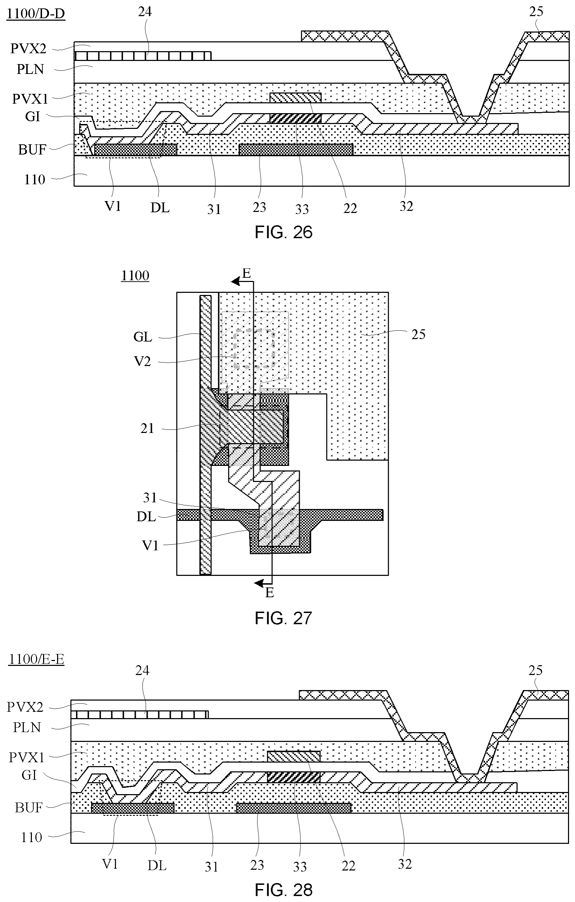

FIG. 25 is a plane view of an array substrate, in accordance with some embodiments of the present disclosure; FIG. 26 is a sectional view of an array substrate, in accordance with some embodiments of the present disclosure.

Referring to FIGS. 25 and 26, in some embodiments, in a section (e.g., the section shown in FIG. 26) taken along a plane perpendicular to the base substrate 110, perpendicular to the direction Y in which the signal line DL extends in length, and intersecting the signal line DL and the first via hole V1, at least part of the signal line DL is covered by the first insulating layer BUF, and at least part of the upper surface of the signal line DL is not exposed in the first via hole V1. For example, in the section shown in FIG. 26, a first portion of the signal line DL is not covered by the first insulating layer BUF, and a second portion of the signal line DL is covered by the first insulating layer BUF. In the section shown in FIG. 26, the upper surface of the first portion of the signal line DL is exposed by the first via hole V1, and the upper surface of the second portion of the signal line DL is not exposed in the first via hole V1. The first portion is located on a side of the second portion away from the channel structure 33.

In some embodiments, referring to FIGS. 25 and 26, in a section (e.g., the section shown in FIG. 26) taken along a plane perpendicular to the base substrate 110, perpendicular to the direction Y in which the signal line DL extend in length, and intersecting the signal line DL and the first via hole V1, the surfaces of the signal line DL except the surface in contact with the base substrate 110 are only partially covered by the first portion 31. For example, in the section shown in FIG. 26, an upper surface of only part of the signal line DL and only one of two side surfaces each connected to both the upper surface and the lower surface of the signal line DL are covered by the first portion 31. The lower surface is a surface of the signal line DL that is in contact with the base substrate 110.

FIG. 27 is a plane view of an array substrate, in accordance with some embodiments of the present disclosure; FIG. 28 is a sectional view of an array substrate, in accordance with some embodiments of the present disclosure; FIG. 28 is a sectional view taken along the section line E-E in FIG. 27.

Referring to FIGS. 27 and 28, in some embodiments, in a section (e.g., the section shown in FIG. 28) taken along a plane perpendicular to the base substrate 110, perpendicular to the direction Y in which the signal line DL extend in length, and intersecting the signal line DL and the first via hole V1, at least part of the signal line DL is covered by the first insulating layer BUF, and at least part of the upper surface of the signal line DL is not exposed in the first via hole V1. For example, in the section shown in FIG. 28, the middle part of the signal line DL is not covered by the first insulating layer BUF, and two portions of the signal line DL at two ends are covered by the first insulating layer BUF. In the section shown in FIG. 28, the upper surface of the middle part of the signal line DL is exposed by the first via hole V1, and the upper surfaces of the two portions of the signal line DL at two ends are not exposed in the first via hole V1.

In some embodiments, referring to FIGS. 27 and 28, in a section (e.g., the section shown in FIG. 28) taken along a plane perpendicular to the base substrate 110, perpendicular to the direction Y in which the signal line DL extend in length, and intersecting the signal line DL and the first via hole V1, the upper surface of only a part of the signal line DL is covered by the first portion 31. The upper surface of the other part of the signal line DL and the two side surfaces each connected to both the upper surface and the lower surface of the signal line DL are not covered by the first portion 31. The lower surface is a surface of the signal line DL that is in contact with the base substrate 110.

In some embodiments, the second insulating layer GI extends substantially in the entire array substrate, as shown in FIGS. 21A to 21E, FIGS. 22A, 22B, 23A and 23B and FIGS. 24 to 28.

In some embodiments, the second insulating layer does not substantially extend in the entire array substrate. For example, the orthographic projection of the second insulating layer on the base substrate substantially coincides with the orthographic projections of the gate 22 and the gate line GL on the base substrate. Moreover, the orthographic projection of the second insulating layer on the base substrate is partially non-overlapping with the orthographic projection of the signal line on the base substrate, and is partially non-overlapping with the orthographic projections of the first portion and the second portion on the base substrate.

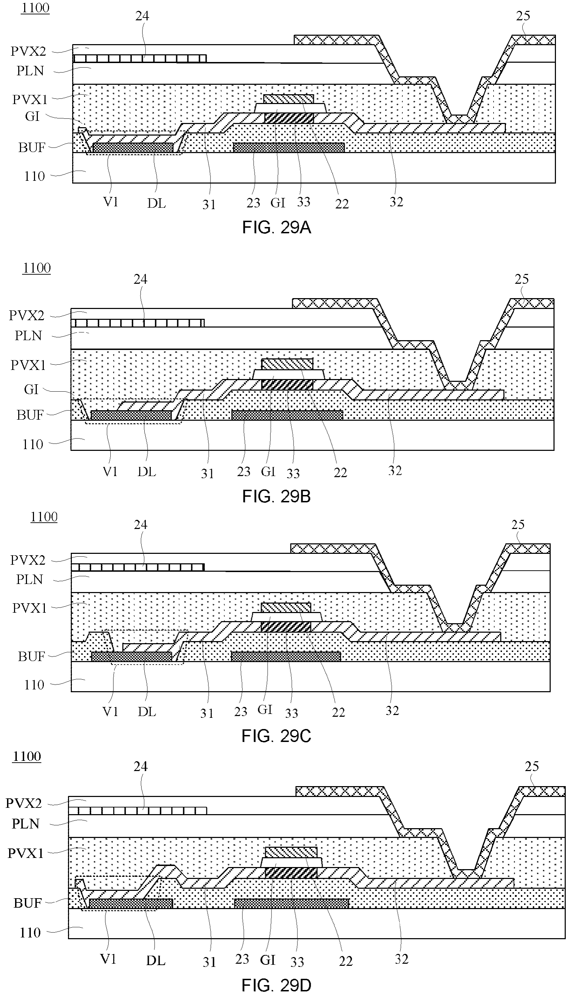

FIG. 29A is a sectional view of an array substrate, in accordance with some embodiments of the present disclosure; the structure shown in FIG. 29A is similar to the structure shown in FIG. 22A, but differs from the structure shown in FIG. 22A at least in that the second insulating layer GI does not substantially extend in the entire array substrate, as shown in FIG. 29A.

FIG. 29B is a sectional view of an array substrate, in accordance with some embodiments of the present disclosure; the structure shown in FIG. 29B is similar to the structure shown in FIG. 22B, but differs from the structure shown in FIG. 22B at least in that the second insulating layer GI does not substantially extend in the entire array substrate, as shown in FIG. 29B.

FIG. 29C is a sectional view of an array substrate, in accordance with some embodiments of the present disclosure; the structure shown in FIG. 29C is similar to the structure shown in FIG. 24, but differs from the structure shown in FIG. 24 at least in that the second insulating layer GI does not substantially extend in the entire array substrate, as shown in FIG. 29C.

FIG. 29D is a sectional view of an array substrate, in accordance with some embodiments of the present disclosure; the structure shown in FIG. 29D is similar to the structure shown in FIG. 26, but differs from the structure shown in FIG. 26 at least in that the second insulating layer GI does not substantially extend in the entire array substrate, as shown in FIG. 29D.

In some embodiments, in the peripheral area of the array substrate, for the thin film transistor (GOA-TFT) structure of the gate driving circuit, the source and drain of the GOA-TFT are located on a side of the semiconductor layer of the GOA-TFT away from the base substrate, and the source and drain of the GOA-TFT are lapped on the electrode regions of the semiconductor layer by providing via hole(s) in the second insulating layer, that is, the second insulating layer covers the semiconductor layer of the GOA-TFT, and the second insulating layer includes third via hole(s), the third via hole penetrates the second insulating layer, and the GOA-TFT is electrically connected to the semiconductor layer of the GOA-TFT through the third via hole(s).

In some embodiments, the second insulating layer may include a plurality of third via holes. For example, there may be a plurality of third via holes connected to the source (or drain), the plurality of third via holes are spaced apart, and there is a protrusion structure formed by at least part of the second insulating layer between adjacent third via holes. The source is connected to the semiconductor layer of the GOA-TFT through the plurality of third via holes. In other words, the source covers the plurality of third via holes, and the portions of the source located in the plurality of third via holes are connected in parallel. The source also covers the second insulating layer between adjacent third via holes, and the source also forms a protruding structure on the second insulating layer between the third via holes. The drain may be configured in the same manner as the source, which will not be described in detail here.

In another aspect, a manufacturing method for an array substrate is provided. In some embodiments, the method includes: forming a signal line on a base substrate; forming a first insulating layer on a side of the signal line away from the base substrate; forming an active layer on a side of the first insulating layer away from the base substrate, the active layer including a first portion, a second portion and a channel structure located between the first portion and the second portion, the first portion including a first portion, and the second portion including a second portion. For example, the method further includes forming a via hole extending through at least the first insulating layer; the first portion is formed to extend through the via hole to be connected to the signal line. Optionally, materials of the second portion and at least part of the first portion is the same as a material of the channel structure, and a process is performed on the second portion and the first portion to make them conductive. The conductivity of the channel structure is different from the conductivity of the first portion and different from the conductivity of the second portion.

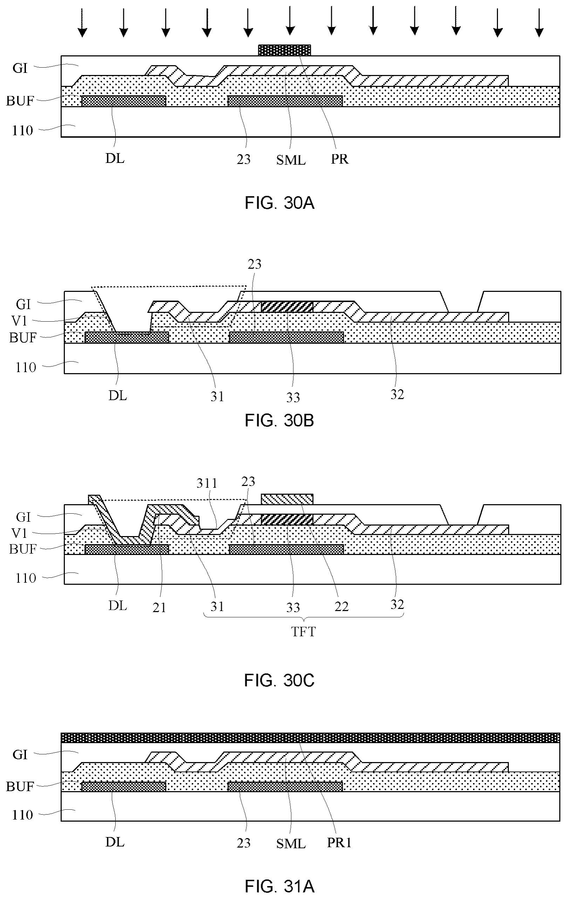

FIGS. 30A to 30C show processes of manufacturing an array substrate, in accordance with some embodiments of the present disclosure.

Referring to FIG. 30A, a signal line DL and a light shielding component 23 are formed on the base substrate 110; a first insulating layer BUF is formed on a side of the signal line DL and the light shielding component 23 away from the base substrate 110; a semiconductor material layer SML is formed on a side of the first insulating layer BUF away from the base substrate 110; a second insulating layer GI is formed on a side of the semiconductor material layer SML away from the base substrate 110; a photoresist layer PR is formed on a side of the second insulating layer GI away from the base substrate 110; and a lightly doped drain process is performed to make portions of the semiconductor material layer SML corresponding to the first portion and the second portion more conductive. An orthographic projection of the photoresist layer PR on the base substrate 110 overlaps with an orthographic projection of a portion of the semiconductor material layer SML corresponding to the channel structure on the base substrate 110. After the lightly doped drain process, the portions of the semiconductor material layer SML corresponding to the first portion and the second portion become more conductive.

Referring to FIG. 30B, the photoresist layer PR is removed and a first via hole V1 is formed. The first via hole V1 extends through the second insulating layer GI and the first insulating layer BUF to expose an upper surface of at least part of the signal line DL (e.g., the middle part of the signal line DL shown in FIG. 30B). Part of the second insulating layer BUF under the first portion may be removed, so that an end of the first portion extends into the first via hole V1 and forms a cantilever structure; that is, the portion of the semiconductor material layer SML corresponding to the first portion extends into the first via hole V1.

Referring to FIG. 30C, an electrode material is deposited and patterned to form a gate 22 and a connection electrode 21. The connection electrode 21 is electrically connected to the first portion 31 (a portion of the semiconductor material layer SML on which a lightly doped drain process is performed), and is at least partially located in the first via hole V1 to be electrically connected to the signal line DL.

In the process of patterning the electrode material, the portion of the first portion 31 located in the first via hole V1 and not covered by the connection electrode 21 may be damaged, resulting in a groove 311 formed in the surface of the first portion 31 away from the base substrate 110. The groove 311 is recessed toward the base substrate 110 to form a groove, or in other words, a thickness of the groove 311 is less than a thickness of other portions of the first portion 31.

FIGS. 31A to 31C show processes of manufacturing an array substrate, in accordance with some embodiments of the present disclosure; FIGS. 31A to 31C show processes of manufacturing an array substrate using a half-tone mask.

Referring to FIG. 31A, a signal line DL and a light shielding component 23 are formed on the base substrate 110; a first insulating layer BUF is formed on a side of the signal line DL and the light shielding component 23 away from the base substrate 110; a semiconductor material layer SML is formed on a side of the first insulating layer BUF away from the base substrate 110; a second insulating layer GI is formed on a side of the semiconductor material layer SML away from the base substrate 110; a first photoresist layer PR is formed on a side of the second insulating layer GI away from the base substrate 110; the first photoresist layer PR1 is exposed using a half-tone mask, and the exposed photoresist layer is developed to obtain a photoresist pattern, the photoresist pattern including a first portion corresponding to the first via hole and a second portion outside the first portion. The first portion includes a first region corresponding to the channel structure and a second region corresponding to a remaining portion of the first portion. A depth of the first region is greater than a depth of the second region. The photoresist material is removed in the second portion. The process further includes etching the second insulating layer GI and the first insulating layer BUF in the second portion to expose an upper surface of at least part of the signal line DL in the second portion, thereby forming the first via hole V1. The process further includes ashing the developed photoresist layer to remove the photoresist material in the second region while retaining the photoresist material in the first region. Thus, a second photoresist layer PR2 in the region corresponding to the channel structure is formed.

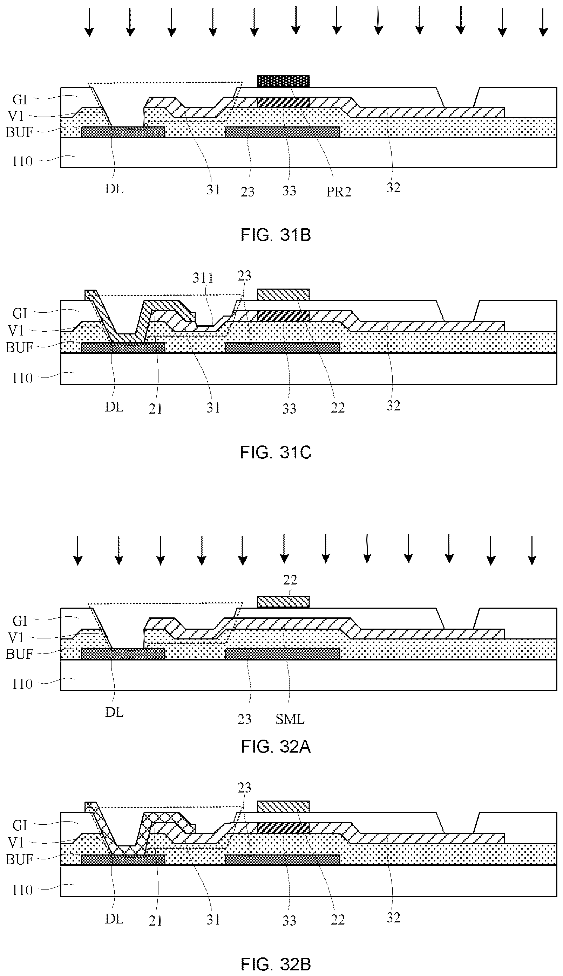

Referring to FIG. 31B, a lightly doped drain process is performed to make the portions of the semiconductor material layer SML corresponding to the first portion and the second portion more conductive. An orthographic projection of the second photoresist layer PR2 on the base substrate 110 coincides with an orthographic projection of the portion of the semiconductor material layer SML corresponding to the channel structure on the base substrate 110. After the lightly doped drain process, the portions of the semiconductor material layer SML corresponding to the first portion and the second portion become more conductive.

Referring to FIG. 31C, an electrode material is deposited and patterned to form a gate 22 and a connection electrode 21. The connection electrode 21 and the first portion 31 (a portion of the semiconductor material layer SML on which the lightly doped drain process is performed) form the first portion 31.

FIGS. 32A to 32B show processes of manufacturing an array substrate, in accordance with some embodiments of the present disclosure.

Referring to FIG. 32A, a signal line DL and a light shielding component 23 are formed on a base substrate 110; a first insulating layer BUF is formed on a side of the signal line DL and the light shielding component 23 away from the base substrate 110; a semiconductor material layer SML is formed on a side of the first insulating layer BUF away from the base substrate 110; a second insulating layer GI is formed on a side of the semiconductor material layer SML away from the base substrate 110; and a first via V1 extending through the second insulating layer GI and the first insulating layer BUF is formed to expose an upper surface of at least part of the signal line DL (e.g., the middle part as shown in FIG. 32A). A portion of the semiconductor material layer SML corresponding to the first portion extends into the first via hole V1. Thus, a gate 22 is formed on a side of the gate insulating layer GI away from the base substrate 110.

Referring to FIG. 32A, the gate 22 is used as a mask, and then a lightly doped drain process is performed to make the portions of the semiconductor material layer SML corresponding to the first portion and the second portion more conductive. An orthographic projection of the gate 22 on the base substrate 110 coincides with an orthographic projection of a portion of the semiconductor material layer SML corresponding to the channel structure on the base substrate 110. After the lightly doped drain process, portions of the semiconductor material layer SML corresponding to the first portion and the second portion become more conductive.

Referring to FIG. 32B, an electrode material is deposited and patterned to form a connection electrode 21. The connection electrode 21 is electrically connected to the first portion 31 (the portion of the semiconductor material layer SML that has undergone the lightly doped drain process) and the signal line DL exposed by the first via hole V1, respectively, thereby electrically connecting the first portion 31 to the signal line DL.

In some embodiments, the second insulating layer GI is formed to extend substantially in the entire array substrate, as shown in FIGS. 30A to 30C, FIGS. 31A to 31C, and FIGS. 32A to 32B.

In some embodiments, the second insulating layer GI is not formed to extend substantially in the entire array substrate. For example, the orthographic projection of the second insulating layer GI on the base substrate is at least partially non-overlapping with the orthographic projection of the signal line on the base substrate, and is at least partially non-overlapping with the orthographic projection of the first portion or the second portion on the base substrate.

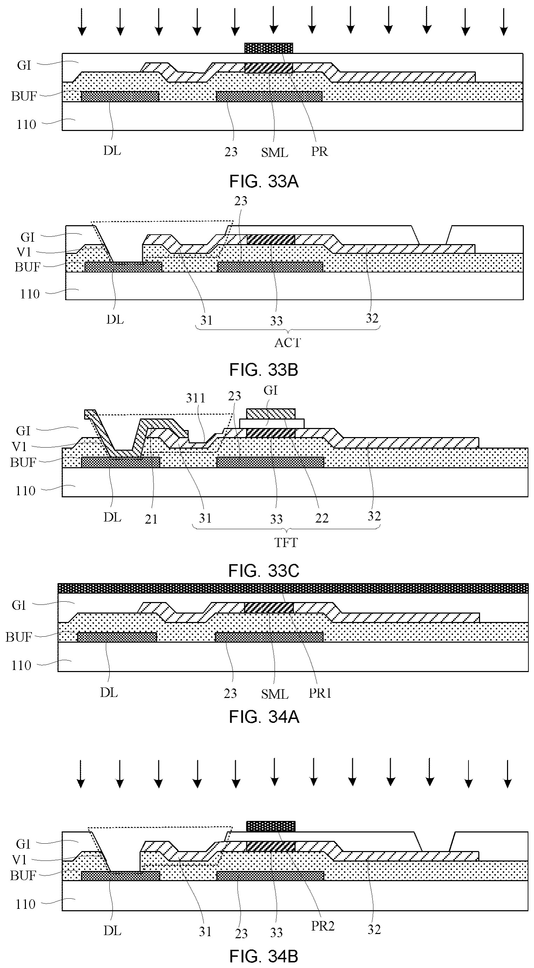

FIGS. 33A to 33C show processes of manufacturing an array substrate, in accordance with some embodiments of the present disclosure. The processes shown in FIGS. 33A to 33C are similar to the processes shown in FIGS. 30A to 30C, but differ from the processes shown in FIGS. 30A to 30C at least in that the second insulating layer GI is not formed to extend substantially in the entire array substrate.

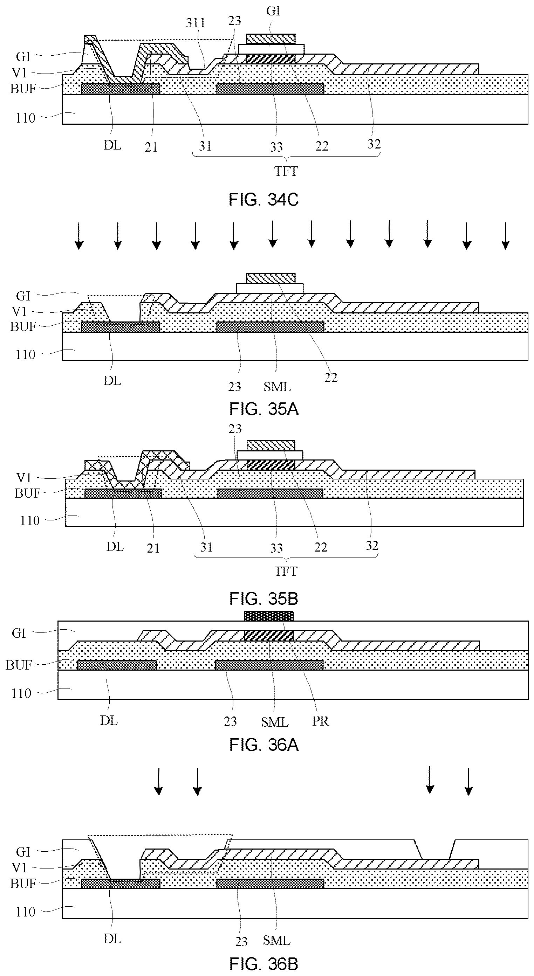

FIGS. 34A to 34C show processes of manufacturing an array substrate, in accordance with some embodiments of the present disclosure; the processes shown in FIGS. 34A to 34C are similar to the processes shown in FIGS. 31A to 31C, but differ from the processes shown in FIGS. 31A to 31C at least in that the second insulating layer GI is not formed to extend substantially in the entire array substrate.

FIGS. 35A to 35B show processes of manufacturing an array substrate, in accordance with some embodiments of the present disclosure. The processes shown in FIGS. 35A to 35B are similar to the processes shown in FIGS. 32A to 32B, but differ from the process shown in FIGS. 32A to 32B at least in that the second insulating layer GI is not formed to extend substantially in the entire array substrate.

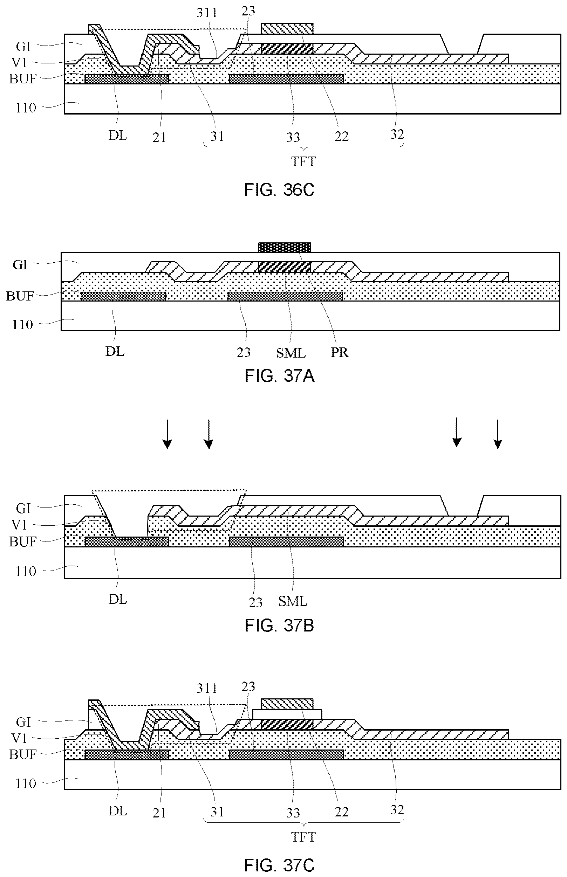

FIGS. 36A to 36C show processes of manufacturing an array substrate, in accordance with some embodiments of the present disclosure. The processes shown in FIGS. 36A to 36C are similar to the processes shown in FIGS. 30A to 30C, but differ from the process shown in FIGS. 30A to 30C at least in that a lightly doped drain process is performed using a mask. In an example, the lightly doped drain process is performed only on a portion of the semiconductor material layer SML extending into the first via hole V1 and a portion of the semiconductor material layer SML corresponding to the second portion.

FIGS. 37A to 37C show processes of manufacturing an array substrate, in accordance with some embodiments of the present disclosure. The processes shown in FIGS. 37A to 37B are similar to the processes shown in FIGS. 36A to 36C, but differ from the processes shown in FIGS. 36A to 36C at least in that the second insulating layer GI is not formed to extend substantially in the entire array substrate.

Example 1: in an example, a method for manufacturing an array substrate includes: cleaning a base substrate; depositing an electrode material layer with a thickness between 100 nm and 1000 nm on the base substrate, the electrode material including but being not limited to a molybdenum-aluminum-aluminum stacked structure, a molybdenum-neodymium-copper stacked structure, an MTD-copper stacked structure, or an MTD-copper-MTD stacked structure; patterning the electrode material layer to form a light shielding component 23 and a signal line DL on the base substrate 110; depositing (for example, by a chemical vapor deposition process) an insulating material (silicon oxide or silicon nitride/silicon oxide) on the base substrate to form a first insulating layer with a thickness between 100 nm and 700 nm; sputtering indium gallium zinc oxide on the base substrate to form a layer with a thickness between 10 nm and 80 nm; patterning the indium gallium zinc oxide material to form a semiconductor material layer; forming, by a chemical vapor deposition process or an atomic layer deposition process, an insulating layer on a side of the semiconductor material layer away from the base substrate by using silicon oxide as an insulating material; performing a lightly doped drain process on the semiconductor material layer; etching the insulating layer and the first insulating layer to form a via hole extending through the insulating layer and the first insulating layer and exposing an upper surface of at least part of the signal line DL; sputtering an electrode material layer with a thickness between 200 nm and 1200 nm on a side of the insulating layer and the first insulating layer away from the base substrate, the electrode material including a molybdenum-neodymium-copper stacked structure, an MTD-copper stacked structure or an MTD-copper-MTD stacked structure; patterning the electrode material layer to form a second portion and a gate; depositing (for example, by a plasma enhanced chemical vapor deposition process) an insulating material (silicon oxide or silicon nitride/silicon oxide) on the base substrate to form a passivation layer with a thickness between 200 nm and 400 nm; forming a resin layer with a thickness between 2 µm and 3 µm by performing a coating process on the first passivation layer; forming, by depositing, a conductive material layer with a thickness between 40 nm and 100 nm on the resin layer using indium gallium zinc oxide or indium zinc oxide, and patterning the conductive material layer to form a common electrode; depositing (for example, by a chemical vapor deposition process) an insulating material (silicon oxide or silicon nitride/silicon oxide) to form a second passivation layer with a thickness between 100 nm and 300 nm on the base substrate; depositing indium zinc oxide on the on the second passivation layer to form a conductive material layer with a thickness between 40 nm and 135 nm; and patterning the conductive material layer to form a pixel electrode. The processes described in Example 1 correspond to the processes described in FIGS. 30A to 30C.

Example 2: in another example, a method for manufacturing an array substrate includes: cleaning a base substrate; forming an electrode material layer with a thickness in a range of 100 nm and 1000 nm on the base substrate by depositing, the electrode material including a molybdenum-aluminum-aluminum stacked structure, a molybdenum-neodymium-copper stacked structure, an MTD-copper stacked structure, or an MTD-copper-MTD stacked structure; patterning the electrode material layer to form a light shielding component 23 and a signal line DL on the base substrate 110; depositing (for example, by a chemical vapor deposition process) an insulating material (silicon oxide or silicon nitride/silicon oxide) on the base substrate to form a first insulating layer with a thickness between 100 nm and 700 nm; sputtering indium gallium zinc oxide on the base substrate to form a layer with a thickness between 10 nm and 80 nm; patterning the indium gallium zinc oxide material to form a semiconductor material layer; forming, by a chemical vapor deposition process or an atomic layer deposition process, an insulating layer on a side of the semiconductor material layer away from the base substrate by using silicon oxide as an insulating material; performing a lightly doped drain process on the semiconductor material layer; etching the insulating layer and the first insulating layer to form a via hole extending through the insulating layer and the first insulating layer and exposing an upper surface of at least part of the signal line DL; sputtering an electrode material layer with a thickness between 200 nm and 1200 nm on a side of the insulating layer and the first insulating layer away from the base substrate, the electrode material including a molybdenum-neodymium-copper stacked structure, an MTD-copper stacked structure or an MTD-copper-MTD stacked structure; patterning the electrode material layer to form a second portion and a gate; patterning the insulating material layer to form an insulating layer, the insulating layer substantially not extending in the entire array substrate, an orthographic projection of the insulating layer on the base substrate being at least partially non-overlapping with an orthographic projection of the signal line on the base substrate, and being at least partially non-overlapping with orthographic projections of the first portion or the second portion on the base substrate; depositing (for example, by a plasma enhanced chemical vapor deposition process) an insulating material (silicon oxide or silicon nitride/silicon oxide) on the base substrate to form a passivation layer with a thickness between 200 nm and 400 nm; forming a resin layer with a thickness between 2 µm and 3 µm by performing a coating process on the first passivation layer; forming, by depositing, a conductive material layer with a thickness between 40 nm and 100 nm on the resin layer using indium gallium zinc oxide or indium zinc oxide, and patterning the conductive material layer to form a common electrode; depositing (for example, by a chemical vapor deposition process) an insulating material (silicon oxide or silicon nitride/silicon oxide) to form a second passivation layer with a thickness between 100 nm and 300 nm on the base substrate; depositing indium zinc oxide on the on the second passivation layer to form a conductive material layer with a thickness between 40 nm and 135 nm; and patterning the conductive material layer to form a pixel electrode. The processes described in Example 2 correspond to the processes described in FIGS. 31A to 31C.

Example 3: in yet another example, a method for manufacturing an array substrate includes: cleaning a base substrate; depositing an electrode material layer with a thickness between 100 nm and 1000 nm on the base substrate, the electrode material including a molybdenum-aluminum-aluminum stacked structure, a molybdenum-neodymium-copper stacked structure, an MTD-copper stacked structure, or an MTD-copper-MTD stacked structure; patterning the electrode material layer to form a light shielding component 23 and a signal line DL on the base substrate 110; depositing (for example, by a chemical vapor deposition process) an insulating material (silicon oxide or silicon nitride/silicon oxide) on the base substrate to form a first insulating layer with a thickness between 100 nm and 700 nm; sputtering indium gallium zinc oxide on the base substrate to form a layer with a thickness between 10 nm and 80 nm; patterning an indium gallium zinc oxide material to form a semiconductor material layer; forming, by a chemical vapor deposition process or an atomic layer deposition process, an insulating layer on a side of the semiconductor material layer away from the base substrate by using silicon oxide as an insulating material; forming a first photoresist layer on a side of the insulating layer away from the base substrate; exposing and developing the first photoresist layer by using a halftone mask; etching the insulating layer and the first insulating layer to form a via hole extending through the insulating layer and the first insulating layer to expose an upper surface of at least part of the signal line; forming a second photoresist layer in a region corresponding to the channel structure; performing a lightly doped drain process on the semiconductor material layer by using the second photoresist layer as a mask; sputtering an electrode material layer with a thickness between 200 nm and 1200 nm on a side of the insulating layer and the first insulating layer away from the base substrate, the electrode material including a molybdenum-neodymium-copper stacked structure, an MTD-copper stacked structure or an MTD-copper-MTD stacked structure; patterning the electrode material layer to form a second portion and a gate; depositing (for example, by a plasma enhanced chemical vapor deposition process) an insulating material (silicon oxide or silicon nitride/silicon oxide) on the base substrate to form a passivation layer with a thickness between 200 nm and 400 nm; forming a resin layer with a thickness between 2 µm and 3 µm by performing a coating process on the first passivation layer; forming, by depositing, a conductive material layer with a thickness between 40 nm and 100 nm on the resin layer using indium gallium zinc oxide or indium zinc oxide, and patterning the conductive material layer to form a common electrode; depositing (for example, by a chemical vapor deposition process) an insulating material (silicon oxide or silicon nitride/silicon oxide) to form a second passivation layer with a thickness between 100 nm and 300 nm on the base substrate; depositing indium zinc oxide on the on the second passivation layer to form a conductive material layer with a thickness between 40 nm and 135 nm; and patterning the conductive material layer to form a pixel electrode. The processes described in Example 3 correspond to the processes described in FIGS. 33A to 33C.

Example 4: in yet another example, a method for manufacturing an array substrate includes: cleaning a base substrate; depositing an electrode material layer with a thickness between 100 nm and 1000 nm on the base substrate, the electrode material including but being not limited to a molybdenum-aluminum-aluminum stacked structure, a molybdenum-neodymium-copper stacked structure, an MTD-copper stacked structure, or an MTD-copper-MTD stacked structure; patterning the electrode material layer to form a light shielding component 23 and a signal line DL on the base substrate 110; depositing (for example, by a chemical vapor deposition process) an insulating material (silicon oxide or silicon nitride/silicon oxide) on the base substrate to form a first insulating layer with a thickness between 100 nm and 700 nm; sputtering indium gallium zinc oxide on the base substrate to form a layer with a thickness between 10 nm and 80 nm; patterning the indium gallium zinc oxide material to form a semiconductor material layer; forming, by a chemical vapor deposition process or an atomic layer deposition process, an insulating layer on a side of the semiconductor material layer away from the base substrate by using silicon oxide as an insulating material; forming a first photoresist layer on a side of the insulating layer away from the base substrate; exposing and developing the first photoresist layer by using a halftone mask; etching the insulating layer and the first insulating layer to form a via hole extending through the insulating layer and the first insulating layer to expose an upper surface of at least part of the signal line; forming a second photoresist layer in a region corresponding to the channel structure; performing a lightly doped drain process on the semiconductor material layer by using the second photoresist layer as a mask; sputtering an electrode material layer with a thickness between 200 nm and 1200 nm on a side of the insulating layer and the first insulating layer away from the base substrate, the electrode material including a molybdenum-neodymium-copper stacked structure, an MTD-copper stacked structure or an MTD-copper-MTD stacked structure; patterning the electrode material layer to form a second portion and a gate; patterning the insulating material layer to form an insulating layer, the insulating layer substantially not extending in the entire array substrate, an orthographic projection of the insulating layer on the base substrate being at least partially non-overlapping with an orthographic projection of the signal line on the base substrate, and being at least partially non-overlapping with orthographic projections of the first portion or the second portion on the base substrate; depositing (for example, by a plasma enhanced chemical vapor deposition process) an insulating material (silicon oxide or silicon nitride/silicon oxide) on the base substrate to form a passivation layer with a thickness between 200 nm and 400 nm; forming a resin layer with a thickness between 2 µm and 3 µm by performing a coating process on the first passivation layer; forming, by depositing, a conductive material layer with a thickness between 40 nm and 100 nm on the resin layer using indium gallium zinc oxide or indium zinc oxide, and patterning the conductive material layer to form a common electrode; depositing (for example, by a chemical vapor deposition process) an insulating material (silicon oxide or silicon nitride/silicon oxide) to form a second passivation layer with a thickness between 100 nm and 300 nm on the base substrate; depositing indium zinc oxide on the on the second passivation layer to form a conductive material layer with a thickness between 40 nm and 135 nm; and patterning the conductive material layer to form a pixel electrode. The processes described in Example 4 correspond to the processes described in FIGS. 34A to 34C.

Example 5: in yet another example, a method for manufacturing an array substrate includes: cleaning a base substrate; depositing an electrode material layer with a thickness between 100 nm and 1000 nm on the base substrate, the electrode material including a molybdenum-aluminum-aluminum stacked structure, a molybdenum-neodymium-copper stacked structure, an MTD-copper stacked structure, or an MTD-copper-MTD stacked structure; patterning the electrode material layer to form a light shielding component 23 and a signal line DL on the base substrate 110; depositing (for example, by a chemical vapor deposition process) an insulating material (silicon oxide or silicon nitride/silicon oxide) on the base substrate to form a first insulating layer with a thickness between 100 nm and 700 nm; sputtering indium gallium zinc oxide on the base substrate to form a layer with a thickness between 10 nm and 80 nm; forming, by a chemical vapor deposition process or an atomic layer deposition process, an insulating layer on a side of the semiconductor material layer away from the base substrate by using silicon oxide as an insulating material; etching the insulating layer and the first insulating layer using a mask to form a via hole extending through the insulating layer and the first insulating layer and exposing an upper surface of at least part of the signal line DL; performing, by using the same mask used to form the first via hole V1, a lightly doped drain process on the portion of the semiconductor material layer extending into the first via hole V1; sputtering an electrode material layer with a thickness between 200 nm and 1200 nm on the side of the insulating material layer and the first insulating layer away from the base substrate, the electrode material including a molybdenum-neodymium-copper stacked structure, an MTD-copper stacked structure or an MTD-copper-MTD stacked structure; patterning the electrode material layer to form a second portion and a gate; depositing (for example, by a plasma chemical vapor deposition process) an insulating material (silicon oxide or silicon nitride/silicon oxide) on the base substrate to form a passivation layer with a thickness between 200 nm and 400 nm; forming a resin layer with a thickness between 2 µm and 3 µm by performing a coating process on the first passivation layer; depositing a conductive material layer with a thickness between 40 nm and 100 nm on the resin layer using indium gallium zinc oxide or indium zinc oxide, and patterning the conductive material layer to form a common electrode; depositing (for example, by a chemical vapor deposition process) an insulating material (silicon oxide or silicon nitride/silicon oxide) on the base substrate to form a second passivation layer with a thickness between 100 nm and 300 nm; depositing a conductive material layer with a thickness between 40 nm and 135 nm on the second passivation layer using indium zinc oxide, and patterning the conductive material layer to form a pixel electrode. The processes described in Example 5 correspond to the processes described in FIGS. 36A to 36C.

Example 6: in yet another example, a method for manufacturing an array substrate includes: cleaning a base substrate; depositing an electrode material layer with a thickness between 100 nm and 1000 nm on the base substrate, the electrode material including a molybdenum-aluminum-aluminum stacked structure, a molybdenum-neodymium-copper stacked structure, an MTD-copper stacked structure, or an MTD-copper-MTD stacked structure; patterning the electrode material layer to form a light shielding component 23 and a signal line DL on the base substrate 110; depositing (for example, by a chemical vapor deposition process) an insulating material (silicon oxide or silicon nitride/silicon oxide) on the base substrate to form a first insulating layer with a thickness between 100 nm and 700 nm; sputtering indium gallium zinc oxide on the base substrate to form a layer with a thickness between 10 nm and 80 nm; patterning an indium gallium zinc oxide material to form a semiconductor material layer; forming, by a chemical vapor deposition process or an atomic layer deposition process, an insulating layer on a side of the semiconductor material layer away from the base substrate by using silicon oxide as an insulating material; etching the insulating layer and the first insulating layer using a mask to form a via hole extending through the insulating layer and the first insulating layer and exposing an upper surface of at least part of the signal line DL; performing, by using the same mask used to form the first via hole V1, a lightly doped drain process on a portion of the semiconductor material layer extending into the first via hole V1; sputtering an electrode material layer with a thickness between 200 nm and 1200 nm on the side of the insulating material layer and the first insulating layer away from the base substrate, the electrode material including a molybdenum-neodymium-copper stacked structure, an MTD-copper stacked structure or an MTD-copper-MTD stacked structure; patterning the insulating material layer to form an insulating layer, the insulating layer substantially not extending in the entire array substrate, an orthographic projection of the insulating layer on the base substrate being at least partially non-overlapping with an orthographic projection of the signal line on the base substrate, and being at least partially non-overlapping with orthographic projections of the first portion or the second portion on the base substrate; depositing (for example, by a plasma enhanced chemical vapor deposition process) an insulating material (silicon oxide or silicon nitride/silicon oxide) on the base substrate to form a passivation layer with a thickness between 200 nm and 400 nm; forming a resin layer with a thickness between 2 µm and 3 µm by performing a coating process on the first passivation layer; forming, by depositing, a conductive material layer with a thickness between 40 nm and 100 nm on the resin layer using indium gallium zinc oxide or indium zinc oxide, and patterning the conductive material layer to form a common electrode; depositing (for example, by a chemical vapor deposition process) an insulating material (silicon oxide or silicon nitride/silicon oxide) to form a second passivation layer with a thickness between 100 nm and 300 nm on the base substrate; depositing indium zinc oxide on the on the second passivation layer to form a conductive material layer with a thickness between 40 nm and 135 nm; and patterning the conductive material layer to form a pixel electrode. The processes described in Example 6 correspond to the processes described in FIGS. 37A to 37C.

Example 7: in yet another example, a method for manufacturing an array substrate includes: cleaning a base substrate; depositing an electrode material layer with a thickness between 100 nm and 1000 nm on the base substrate, the electrode material including a molybdenum-aluminum-aluminum stacked structure, a molybdenum-neodymium-copper stacked structure, an MTD-copper stacked structure, or an MTD-copper-MTD stacked structure; patterning the electrode material layer to form a light shielding component 23 and a signal line DL on the base substrate 110; depositing (for example, by a chemical vapor deposition process) an insulating material (silicon oxide or silicon nitride/silicon oxide) on the base substrate to form a first insulating layer with a thickness between 100 nm and 700 nm; sputtering indium gallium zinc oxide on the base substrate to form a layer with a thickness between 10 nm and 80 nm; patterning an indium gallium zinc oxide material to form a semiconductor material layer; forming, by a chemical vapor deposition process or an atomic layer deposition process, an insulating layer on a side of the semiconductor material layer away from the base substrate by using silicon oxide as an insulating material; etching the insulating layer and the first insulating layer to form a via hole extending through the insulating layer and the first insulating layer and exposing an upper surface of at least part of the signal line DL; sputtering an electrode material layer with a thickness between 200 nm and 1200 nm on a side of the insulating material layer and the first insulating layer away from the base substrate, the electrode material including a molybdenum-neodymium-copper stacked structure, an MTD-copper stacked structure or an MTD-copper-MTD stacked structure; patterning the electrode material layer to form a gate; performing a lightly doped drain process on the semiconductor material layer by using the gate as a mask; sputtering an electrode material layer with a thickness between 200 nm and 1200 nm, the electrode material layer including a molybdenum-neodymium-copper stacked structure, an MTD-copper stacked structure or an MTD-copper-MTD stacked structure; patterning the electrode material layer to form a second portion at least partially in the first via hole V1; depositing (for example, by a plasma enhanced chemical vapor deposition process) an insulating material (silicon oxide or silicon nitride/silicon oxide) on the base substrate to form a first passivation layer with a thickness between 200 nm and 400 nm; forming a resin layer with a thickness between 2 µm and 3 µm on the first passivation layer by coating; depositing a conductive material layer with a thickness between 40 nm and 100 nm on the resin layer by using indium gallium zinc oxide or indium zinc oxide, and patterning the conductive material layer to form a common electrode; depositing (for example, by a chemical vapor deposition process) an insulating material (silicon oxide or silicon nitride/silicon oxide) on the substrate to form a second passivation layer with a thickness between 100 nm and 300 nm; depositing a conductive material layer with a thickness between 40 nm and 135 nm on the second passivation layer by using indium zinc oxide; and patterning the conductive material layer to form a pixel electrode. The processes described in Example 7 correspond to the processes described in FIGS. 35A to 35B.

The foregoing descriptions are merely specific implementations of the present disclosure, but the protection scope of the present disclosure is not limited thereto, any changes or replacements that a person skilled in the art could conceive of within the technical scope of the present disclosure shall be included in the protection scope of the present disclosure. Therefore, the protection scope of the present disclosure should be determined by the protection scope of the claims.

## Claims

1. An array substrate, comprising:
a base substrate;
a signal line disposed on the base substrate;
a first insulating layer located on a side of the signal line away from the base substrate;
an active layer located on a side of the first insulating layer away from the base substrate; the active layer including a first portion, a second portion and a channel structure located between the first portion and the second portion; and
a first via hole penetrating at least the first insulating layer and exposing at least part of the signal line;
wherein the first portion is configured to be connected to the signal line through the first via hole; materials of the second portion and the first portion is same as a material of the channel structure; a conductivity of the channel structure is different from a conductivity of the first portion and a conductivity of the second portion.

2. The array substrate according to claim 1, further comprising:
a connection electrode located on a side of the active layer away from the base substrate, wherein the connection electrode is electrically connected to both the signal line and the first portion, the first portion is configured to be electrically connected to the signal line through the connection electrode.

3. The array substrate according to claim 2, further comprising:
a second insulating layer located between the active layer and the connection electrode;
wherein the first via hole penetrates the second insulating layer and the first insulating layer, and the first via hole further exposes at least part of the first portion; and
at least part of the connection electrode is located in the first via hole, and an orthographic projection of the connection electrode on the base substrate partially overlaps with an orthographic projection of the first portion on the base substrate, and partially overlaps with an orthographic projection of the signal line on the base substrate.

4. The array substrate according to claim 3, wherein
the orthographic projection of the first portion on the base substrate partially overlaps with the orthographic projection of the signal line on the base substrate.

5. The array substrate according to claim 4, wherein
the array substrate comprises a first connection region defined by the first via hole, the first connection region includes a first region, a second region and a third region that are sequentially connected in a direction away from the channel structure; an orthogonal projection of the first region on the base substrate partially overlaps with the orthographic projection of the first portion on the base substrate, and is non-overlapping with the orthographic projection of the signal line on the base substrate; an orthogonal projection of the second region on the base substrate partially overlaps with the orthographic projection of the first portion on the base substrate, and is located within the orthographic projection of the signal line on the base substrate; an orthogonal projection of the third region on the base substrate is located outside the orthographic projection of the first portion on the base substrate, and at least partially overlaps with the orthographic projection of the signal line on the base substrate; and
the connection electrode covers at least part of the second region and the third region.

6. The array substrate according to claim 5, wherein
in the first region, the array substrate comprises the first insulating layer and the first portion that are stacked;
in the second region, the array substrate comprises the signal line, the first insulating layer, the first portion and the connection electrode that are stacked; and
in the third region, the array substrate comprises the signal line and the connection electrode that are stacked.

7. The array substrate according to claim 6, wherein
the connection electrode covers at least part of the first region;
at the position where the first region is located, the array substrate further includes the connection electrode disposed on a side of the first portion away from the connection electrode.

8. The array substrate according to claim 5 or 6, wherein the connection electrode exposes at least part of the first region;
the first portion includes a groove that is recessed toward the base substrate, the groove is located in the first region, and an orthographic projection of the groove on the base substrate is non-overlapping with the orthographic projection of the connection electrode on the base substrate.

9. The array substrate according to any one of claims 5 to 8, further comprising:
the signal line, the first insulating layer, the first portion, and the connection electrode forming a protruding structure in the second region that protrudes toward a side away from the base substrate relative to the first region and the third region.

10. The array substrate according to any one of claims 5 to 9, wherein
the first portion and/or the second portion includes a zigzag structure at an edge of the second region proximate to the first region.

11. The array substrate according to claim 3, wherein
the orthographic projection of the first portion on the base substrate is non-overlapping with the orthographic projection of the signal line on the base substrate.

12. The array substrate according to claim 11, wherein
the array substrate comprises a first connection region defined by the first via hole, the first connection region includes a fourth region and a fifth region that are sequentially connected in a direction away from the channel structure; an orthogonal projection of the fourth region on the base substrate at least partially overlaps with the orthographic projection of the first portion on the base substrate, and is non-overlapping with the orthographic projection of the signal line on the base substrate; an orthogonal projection of the fifth region on the base substrate at least partially overlaps with the orthographic projection of the signal line on the base substrate, and is non-overlapping with the orthographic projection of the first portion on the base substrate; and
the connection electrode covers at least part of the fourth region and at least part of the fifth region.

13. The array substrate according to claim 12, wherein
in the fourth region, the array substrate comprises the first insulating layer, the first portion, and the connection electrode that are stacked; and
in the fifth region, the array substrate comprises the signal line and the connection electrode that are stacked.

14. The array substrate according to claim 12 or 13, wherein the connection electrode exposes at least part of the fourth region;
the first portion includes a groove that is recessed toward the base substrate, the groove is located in the fourth region, and an orthographic projection of the groove on the base substrate is non-overlapping with the orthographic projection of the connection electrode on the base substrate.

15. The array substrate according to any one of claims 12 to 14, wherein
the connection electrode includes a step structure, the step structure includes a first step located in the fourth region and a second step located in the fifth region; the first step is farther away from the base substrate than the second step.

16. The array substrate according to any one of claims 2 to 15, wherein the material of the first portion is different from a material of the connection electrode.

17. The array substrate according to claim 16, wherein the channel structure, the first portion and the second portion are of one piece structure; wherein
the material of the first portion includes M1 OaNb, wherein M1 is a single metal or a combination of multiple metals, a > 0, and b ≥ 0, O represents oxygen element, and N represents nitrogen element; and
the material of the connection electrode includes a metal material.

18. The array substrate according to any one of claims 2 to 17, wherein at least part of the first portion extends into the connection electrode.

19. The array substrate according to any one of claims 2 to 18, further comprising:
a second insulating layer located between the active layer and the connection electrode; and
a gate located on a side of the second insulating layer away from the base substrate;
wherein the connection electrode and the gate are located in a same layer and include a same material.

20. The array substrate according to claim 1, wherein
the first via hole penetrates through the first insulating layer; and
at least part of the first portion is located in the first via hole, and the first portion is in contact with and connected to the signal line through the first via hole.

21. The array substrate according to claim 20, wherein the channel structure, the first portion and the second portion are of a one piece structure; wherein
the material of the first portion includes M1OaNb, wherein M1 is a single metal or a combination of multiple metals, a > 0, and b ≥ 0, O represents oxygen element, and N represents nitrogen element.

22. The array substrate according to any one of claims 1 to 21, wherein the first portion, the channel structure, and the second portion are arranged substantially along a straight line.

23. The array substrate according to claim 22, further comprising:
a gate line disposed on a side of the active layer away from the base substrate, wherein the gate line extends in a first direction; and
a gate located in a same layer as the gate, and including a same material as the gate, wherein the gate extends in a second direction, and an end of the gate is connected to the gate line; the first direction intersects the second direction;
wherein the signal line extends in the second direction; and
the first portion, the channel structure, and the second portion extend substantially in the first direction.

24. The array substrate according to claim 23, wherein
the gate line includes a first extension segment and a second extension segment, an orthographic projection of the first extension segment on the base substrate is non-overlapping with an orthographic projection of the signal line on the base substrate, and an orthographic projection of the second extension segment on the base substrate overlaps with the orthographic projection of the signal line on the base substrate; and
in the second direction, a dimension of the first extension segment is less than a dimension of the second extension segment.

25. The array substrate according to claim 24, wherein
the dimension of the first extension section in the second direction is denoted as D1, and a value of D1 is in a range of 2 µm to 6 µm; and
the dimension of the second extension section in the second direction is denoted as D2, D2 = D1 + H, and a value of H is in a range of 0.2 µm to 1.5 µm.

26. The array substrate according to any one of claims 1 to 25, further comprising:
a third insulating layer located on a side of the connection electrode away from the base substrate;
a planarization layer disposed on a side of the third insulating layer away from the base substrate;
a second via hole penetrating at least the third insulating layer and the planarization layer, wherein an orthogonal projection of the second via hole on the base substrate at least partially overlaps with an orthographic projection of the second portion on the base substrate; and
a pixel electrode disposed on a side of the planarization layer away from the base substrate, wherein the pixel electrode extends through the second via hole and is electrically connected to the second portion.

27. The array substrate according to claim 26, wherein
the second via hole includes a first sub-hole penetrating the third insulating layer and a second sub-hole penetrating the planarization layer; wherein
an orthogonal projection of the second sub-hole on the base substrate covers an orthogonal projection of the first sub-hole on the base substrate, and a center of the orthogonal projection of the second sub-hole on the base substrate and a center of the orthogonal projection of the first sub-hole on the base substrate have a spacing therebetween.

28. The array substrate according to claim 27, wherein
the first portion, the channel structure and the second portion are arranged substantially in the first direction;
the center of the orthogonal projection of the second sub-hole on the base substrate is spaced apart from the center of the orthogonal projection of the first sub-hole on the base substrate in the first direction.

29. The array substrate according to claim 26, wherein
the second via hole includes a first sub-hole penetrating the third insulating layer and a second sub-hole penetrating the planarization layer; wherein
a boundary of the orthogonal projection of the second sub-hole on the base substrate substantially coincides with a boundary of the orthogonal projection of the first sub-hole on the base substrate, and the center of the orthogonal projection of the second sub-hole on the base substrate substantially coincides with the center of the orthogonal projection of the first sub-hole on the base substrate.

30. The array substrate according to any one of claims 26 to 29, further comprising:
a transfer electrode located between the active layer and the third insulating layer and electrically connected to the second portion;
wherein the second via hole exposes at least part of the transfer electrode, the pixel electrode is electrically connected to the transfer electrode and is electrically connected to the second portion through the transfer electrode.

31. The array substrate according to any one of claims 26 to 29, wherein the second via hole exposes at least part of the second portion, and the pixel electrode is in contact with and connected to the second portion.

32. The array substrate according to any one of claims 26 to 31, further comprising:
a supporting block located on a side of the pixel electrode away from the base substrate, wherein an orthographic projection of the supporting block on the base substrate at least partially overlaps with an orthogonal projection of a second sub-hole on the base substrate;
wherein at least part of the second sub-hole is filled with the supporting block.

33. The array substrate according to any one of claims 1 to 25, further comprising:
a pixel electrode located in a same layer as the active layer and including a same material as the active layer, wherein the pixel electrode and the second portion are of a one piece structure.

34. The array substrate according to any one of claims 11 to 33, wherein in a section taken along a plane perpendicular to the base substrate, perpendicular to a direction in which the signal line extends in length, and intersecting the signal line and the first via hole, surfaces of the signal line except a lower surface are exposed in the first via hole; the lower surface refers to a surface of the signal line in contact with the base substrate.

35. The array substrate according to claim 34, wherein in the section, an upper surface of the signal line and two side surfaces each connected to both an upper surface and the lower surface of the signal line are completely covered by the first portion or the connection electrode.

36. The array substrate according to claim 34, wherein in the section, only an upper surface of a part of the signal line and only one of two side surfaces each connected to both an upper surface and the lower surface of the signal line are covered by the first portion or the connection electrode.

37. The array substrate according to any one of claims 11 to 33, wherein in a section taken along a plane perpendicular to the base substrate, perpendicular to a direction in which the signal line extends in length, and intersecting the signal line and the first via hole, at least part of an upper surface of the signal line and at least one of two side surfaces each connected to both the upper surface and the lower surface of the signal line are not exposed in the first via hole; wherein
the lower surface refers to a surface of the signal line in contact with the base substrate.

38. The array substrate according to claim 37, wherein in the section, only an upper surface of a part of the signal line and at least one of the two side surfaces each connected to both the upper surface and the lower surface of the signal line are covered by the first insulating layer.

39. The array substrate according to claim 37, wherein in the section, only an upper surface of a part of the signal line and only one of the two side surfaces each connected to both the upper surface and the lower surface of the signal line are covered by the first portion or the connection electrode.

40. The array substrate according to claim 37, wherein in the section, only an upper surface of a middle portion of the signal line is covered by the first portion or the connection electrode, and
the two side surfaces each connected to both the upper surface and the lower surface of the signal line are covered by the first insulating layer.

41. The array substrate according to any one of claims 1 to 40, wherein the signal line is configured to provide a data signal for the first portion.

42. The array substrate according to claim 1, wherein the active layer includes a metal oxide material with a hall mobility greater than or equal to 30 cm2/V.s.

43. The array substrate according to claim 1, further comprising: a light shielding component located on the base substrate and a gate line located on a side of the active layer away from the base substrate;
wherein the light shielding component and the signal line are located in a same layer and includes a same material; and
in a direction perpendicular to a direction in which the gate line extends in length, a ratio of a line width of the gate line to a line width of the light shielding component is in a range of 0.3 to 0.9.

44. A display apparatus, comprising:
the array substrate according to any one of claims 1 to 43; and
a driving circuit board electrically connected to the array substrate and configured to transmit a control signal to the array substrate.
